# EUROPEAN PATENT APPLICATION

(11) **EP 4 135 484 A1**
(43) Date of publication of application: **15.02.2023**
(21) Application number: 22185182.7
(22) Date of filing: 15.07.2022
(51) Int. Cl.: H05G 2/00

(54) **STORAGE AND DRAINAGE MECHANISM, LIGHT SOURCE APPARATUS, AND STORAGE AND DRAINAGE METHOD**

(30) Priority: 11.08.2021 JP 2021131189
(71) Applicant: Ushio Denki Kabushiki Kaisha, Tokyo 100-8150 (JP)
(72) Inventor: Yamatani, Daiki, Tokyo (JP); Nagano, Akihisa, Tokyo (JP); Sato, Fuki, Tokyo (JP); Miyagawa, Nobuaki, Tokyo (JP)
(74) Representative: Tomerius, Isabel

(57) **Abstract**

A storage and drainage mechanism (4) includes a storage vessel (40), a drainage section (41), and a temperature controller (64). The storage vessel (40) stores a stored material (SU) containing metal of plasma raw material (SA, SB) at a temperature at which the stored material (SU) is in a liquid-phase state. The drainage section (41) includes a drain pipe (50) including an inlet (53) through which the stored material (SU) flows in, and an outlet (54) through which the stored material (SU) drains away, the drain pipe (50) being communicated with an interior of the storage vessel (40), and a temperature control element (46) that adjusts a temperature of the drain pipe (50). The temperature controller (64) controls the temperature control element (46) to switch the temperature of the drain pipe (50) in a manner that the stored material (SU) in the drain pipe (50) is in either a liquid-phase state or a solid-phase state.

## Description

### CROSS-REFERENCE TO RELATED APPLICATION(S)

This application claims priority from Japanese Priority Patent Application No. 2021-131189 filed August 11, 2021. The entire teachings of the above application are incorporated herein by reference.

### BACKGROUND

This invention relates to a storage and drainage mechanism, a light source apparatus, and a storage and drainage method for collecting a stored material containing metals that serve as plasma raw material stored in a storage vessel.

In recent years, a light source for exposure has been being developed to emit light having a shorter wavelength as semiconductor integrated circuits are miniaturized and highly integrated. As a next-generation light source for semiconductor exposure systems, an extreme ultraviolet (hereinafter, occasionally referred to as "EUV") light source apparatus that emits extreme ultraviolet light having a wavelength of, particularly, 13.5 nm is being developed.

Several methods are known to emit EUV light (EUV emission) from the EUV light source apparatus. One of such methods involves a method of generating plasma by heating and exciting an extreme ultraviolet light emission seed (EUV emission seed), and extracting EUV light from the plasma. EUV light source apparatuses that employ such a method are categorized into a laser produced plasma (LPP) method and a discharge produced plasma (DPP) method.

A DPP-based EUV light source apparatus applies a high voltage to a gap between a pair of electrodes, at which a discharge gas containing an extreme ultraviolet light emission seed (gas-phase plasma raw material) has been supplied, to generate high-density plasma upon electric discharging, and then uses extreme ultraviolet light emitted therefrom. In the DPP-based EUV light source apparatus as disclosed in, for example, Japanese Patent Application Laid-Open Publication No. 2017-219698, a method has been proposed that involves supplying a surface of the electrodes, between which discharge is generated, with a liquid plasma raw material, for example, Sn (tin) or Li (lithium), irradiating the raw material with an energy beam such as a laser beam for evaporation thereof, and then generating plasma upon the electric discharging. This method is sometimes referred to as a laser assisted discharge produced plasma (LDP) method. In contrast, an LPP-based EUV light source apparatus irradiates a target material with a laser beam to excite the target material, then generating plasma.

EUV light source apparatuses are used as light source apparatuses for lithography systems on manufacturing semiconductor devices. Alternatively, EUV light source apparatuses are used as light source apparatuses for mask inspection systems used in lithography. In other words, the EUV light source apparatuses are used as light source apparatuses for other optical systems (utilization apparatus) that use EUV light. Since EUV light attenuates significantly in the atmosphere, the space region through which EUV light passes from the plasma that has been generated in the light source apparatus to the utilization apparatus is placed in a reduced-pressure atmosphere or vacuum environment to suppress the attenuation of the EUV light.

In such apparatuses that generate plasma, the plasma releases debris at high speed. Debris includes particles of the plasma raw material (or particles of tin when the plasma raw material is tin). When plasma is generated in the DPP or LDP method, the debris may also contain particles of the material of discharge electrodes, which have been sputtered due to the generation of the plasma. Upon reaching the utilization apparatus, the debris generated from the plasma may damage or contaminate the reflective coating of the optical element in the utilization apparatus, degrading its performance.

Hence, a debris mitigation device (also referred to as debris mitigation tool (DMT)) has been proposed to capture the released debris to prevent it from entering the utilization apparatus as disclosed in, for example, Japanese Patent Application Laid-Open Publication No. 2017-219698. At least part of the debris captured by the debris mitigation device is heated by heat from heaters or radiation heat from the plasma and enters a liquid-phase state. The molten debris is collected below the apparatus by gravity and stored as waste raw materials in a predetermined storage vessel.

A heat shield plate is placed between the debris mitigation device and the plasma. The heat shield plate is heated by the radiation heat of the plasma. When the debris that has been deposited on the heat shield plate reaches a certain amount, it is collected below the apparatus as droplets and stored in a storage vessel. In addition, part of the plasma raw material (tin) that is to be supplied to a discharge section such as discharge electrodes may leak. Such leaked raw material does not contribute to generation of the plasma, thus it passes through the lower part of the apparatus and is stored in the storage vessel in the same manner as debris. The storage vessel is heated above the melting point of the plasma raw material. Therefore, the plasma raw material in the storage vessel is immediately melted and stored in the storage vessel in a liquefied state.

Since the molten metal gradually accumulates in the storage vessel, it is necessary to monitor the amount of molten metal stored in the vessel to determine the timing of its collection. One method for monitoring the amount of molten metal in a vessel that stores the molten metal is, for example, to detect the liquid surface level of the waste raw materials in the vessel. For example, Japanese Patent No. 6241407 discloses a sensor that determines a liquid surface level by detecting the electric current flowing through a metal rod disposed in the vessel and the molten metal stored in the vessel. Other known methods include a temperature sensor that detects a liquid surface level of tin by the temperature change and a laser displacement meter that detects a liquid surface level of tin by the reflection of a laser beam.

### SUMMARY OF THE INVENTION

In the case of collecting the stored material from the storage vessel in which materials containing metal of the plasma raw material is stored, for example, it is necessary to detach the storage vessel from the main body of the light source apparatus. This case involves stopping the light-emitting operation and heating of the storage vessel, solidifying the stored material in the storage vessel, and detaching the storage vessel from the apparatus main body that has been open to the atmosphere. This case also involves replacing the detached storage vessel with an empty storage vessel or removing the stored material from the detached storage vessel and mounting it to the apparatus again.

In addition, when sensors including level sensors such as the above-mentioned metal rod are used, the stored material solidifies with the metal rod immersed in the stored material. Hence, when the storage vessel is detached from the light source apparatus, the metal rod for sensing also needs to be detached from the light source apparatus. Similarly, when the storage vessel is attached to the light source apparatus, the metal rod also needs to be attached again, which may increase the work time.

Thus, when the stored material in the storage vessel containing, for example, metal of the plasma raw material is collected, the method of detaching the storage vessel from the apparatus main body may take time to restart the apparatus, which may result in long downtime. Therefore, there is a need for a technology that is capable of collecting the stored material in the storage vessel without detaching the storage vessel from the apparatus.

In view of the above circumstances, it is desirable to provide a storage and drainage mechanism, a light source apparatus, and a storage and drainage method that are capable of collecting a stored material containing metal of the plasma raw material without detaching the storage vessel.

In order to achieve the above-mentioned object, a storage and drainage mechanism according to one embodiment of the present invention includes a storage vessel, a drainage section, and a temperature controller. The storage vessel stores a stored material containing metal of plasma raw material at a temperature at which the stored material is in a liquid-phase state. The drainage section includes a drain pipe including an inlet through which the stored material flows in, and an outlet through which the stored material drains away, the drain pipe being communicated with an interior of the storage vessel, and a temperature control element that adjusts a temperature of the drain pipe. The temperature controller controls the temperature control element to switch the temperature of the drain pipe in a manner that the stored material in the drain pipe is in either a liquid-phase state or a solid-phase state.

The storage and drainage mechanism is provided with a drain pipe communicating with the storage vessel that stores the stored material containing metal of the plasma raw material in a liquid-phase state. The drain pipe is provided with a temperature control element that switches the temperature of the drain pipe so that the stored material in the drain pipe is in either a liquid-phase state or a solid-phase state. This makes it possible to collect the stored material containing the metal of the plasma raw material without detaching the storage vessel.

The drainage section may include an aperture that is located in a channel of the drain pipe and that constitutes an aperture channel having a cross-sectional area smaller than the channel of the drain pipe.

The drain pipe may include a bent portion at which the drain pipe is bent such that at least part of a lower end of a channel inner surface of the drain pipe is located higher than an upper end of the inlet.

The aperture may be disposed between the inlet and the bent portion.

The drain pipe may be connected to the storage vessel such that a lower end of the inlet is located higher than a bottom of the interior of the storage vessel by a predetermined distance.

The temperature controller may control the temperature of the drain pipe such that the stored material is in a liquid-phase state when a drainage operation in which the stored material is drained away is performed, and may control the temperature of the drain pipe such that the stored material is in a solid-phase state when a storage operation in which the stored material is stored without draining the stored material is performed.

The storage and drainage mechanism may further include a volume sensor that detects an amount of the stored material in the storage vessel. In this case, the temperature controller may control the temperature control element in response to a detection result of the volume sensor.

The drainage operation may be performed in a state in which a pressure at the outlet is substantially equal to a pressure inside the storage vessel, or the pressure at the outlet is less than the pressure inside the storage vessel.

The pressure at the outlet and the pressure inside the storage vessel may be less than or equal to atmospheric pressure.

The storage and drainage mechanism may further include a collection vessel that collects the stored material that has been drained away from the outlet of the drain pipe.

The collection vessel may be configured as an insulated vessel.

The collection vessel may be connected to an exhaust section that reduces the pressure inside the collection vessel.

The drainage section may include a collection pipe that connects the drain pipe to the collection vessel. In this case, the temperature control element may adjust a temperature of the collection pipe.

The collection pipe may include a flange that is detachably connected to the collection vessel, and a nozzle that protrudes from the flange into the interior of the collection vessel.

A light source apparatus according to one embodiment of the present invention includes a light source section, a storage vessel, a drainage section, and a temperature controller. Plasma emitting extreme ultraviolet light from plasma raw material containing metal is generated in the light source section. The storage vessel stores debris containing metal released from the plasma as a stored material at a temperature at which the stored material is in a liquid-phase state. The drainage section includes a drain pipe including an inlet through which the stored material flows in and an outlet through which the stored material drains away, and a temperature control element that adjusts a temperature of the drain pipe, the drain pipe being communicated with an interior of the storage vessel. The temperature controller controls the temperature control element to switch the temperature of the drain pipe in a manner that the stored material in the drain pipe is in either a liquid-phase state or a solid-phase state.

A storage and drainage method according to one embodiment of the present invention includes adjusting a temperature of a storage vessel in a manner that a stored material containing metal of plasma raw material is in a liquid-phase state. A temperature of a drain pipe is switched by controlling a temperature control element provided in the drain pipe in a manner that the stored material in the drain pipe that communicates with the interior of the storage vessel is in either a liquid-phase state or a solid-phase state.

According to the present invention, it is possible to collect the stored material containing metal of the plasma raw material without detaching the storage vessel.

### BRIEF DESCRIPTION OF DRAWINGS

FIG. 1 is a schematic cross-sectional view illustrating a configuration of an EUV light source apparatus including a foil trap according to an embodiment of the present invention.
FIG. 2 is a side cross-sectional view illustrating a debris capture section in detail.
FIG. 3 is a schematic cross-sectional view illustrating an example of the configuration of a debris storage and drainage section.
FIG. 4 is a block diagram illustrating an example of a temperature control system.
FIG. 5A is a schematic view, to describe the role of a drain pipe, illustrating a state in which stored material drains away from a debris storage vessel through the drain pipe during drainage operation.
FIG. 5B is a schematic view, to describe the role of the drain pipe, illustrating a state in which the stored material stops draining away after the state shown in FIG. 5A.
FIG. 6A is a schematic view, to describe the role of the aperture, illustrating a state in which after the stored material has stopped draining away, the stored material solidifies with stopping heating the drain pipe.
FIG. 6B is a schematic view, to describe the role of the aperture, illustrating the drainage operation with the drain pipe having an outlet extending downward.
FIG. 7 is a schematic view illustrating an example of the configuration of a drain pipe as a comparative example.
FIG. 8 is a flowchart illustrating an example of the basic operation of the debris storage and drainage section.
FIG. 9 is a schematic view illustrating the basic flow of operation of the debris storage and drainage section.
FIG. 10 is a schematic view illustrating the basic flow of operation of the debris storage and drainage section.
FIG. 11 is a schematic view illustrating the basic flow of operation of the debris storage and drainage section.
FIG. 12 is a schematic view illustrating the basic flow of operation of the debris storage and drainage section.
FIG. 13 is a schematic view illustrating the basic flow of operation of the debris storage and drainage section.
FIG. 14 is a schematic view illustrating an example of the configuration of the debris storage and drainage section including a debris collection vessel.
FIG. 15 is a schematic view illustrating an example of the configuration of a collection pipe.

### DETAILED DESCRIPTION OF THE EMBODIMENTS

Hereinafter, with reference to the accompanying drawings, embodiments according to the present invention will be described.

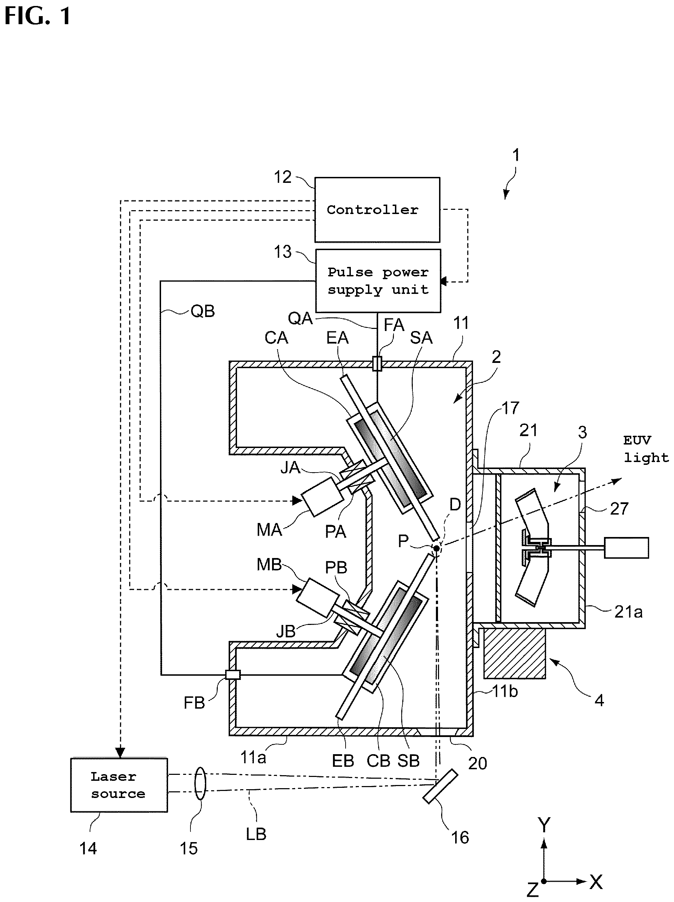

FIG. 1 is a schematic cross-sectional view illustrating the configuration of a EUV light source apparatus 1 provided with a foil trap according to an embodiment of the present invention. In the present embodiment, an example of an LDP-based extreme ultraviolet light source apparatus (EUV light source apparatus) for an inspection system is described as the EUV light source apparatus 1.

In the figure, the X, Y, and Z axes represent three mutually orthogonal axial directions, and the Z axis corresponds to the vertical direction (direction of gravity). Thus, FIG. 1 shows a cross-sectional view of the EUV light source apparatus 1 when it is cut horizontally.

### Overall configuration

In FIG. 1, the EUV light source apparatus 1 emits extreme ultraviolet (EUV) light. The extreme ultraviolet light has a wavelength of 13.5 nm, for example. Specifically, the EUV light source apparatus 1 irradiates liquid-phase plasma raw materials SA and SB, which have been supplied onto the surfaces of a pair of discharge electrodes EA and EB that generate discharges, respectively, with an energy beam such as a laser beam LB to vaporize the plasma raw materials SA and SB. The discharge of the discharge region D between the discharge electrodes EA and EB then generates plasma P. The plasma P emits EUV light.

The EUV light source apparatus 1 can be used, for example, as a light source apparatus in a mask inspection system used for lithography. In this case, part of the EUV light emitted from the plasma P is extracted through a window 27 (light extraction section) and guided to the mask inspection system. The mask inspection system uses the EUV light emitted from the window 27 of the EUV light source apparatus 1 as an inspection light to perform a mask blanks inspection or a mask pattern inspection. Using EUV light can support a process of 5 nm to 7 nm.

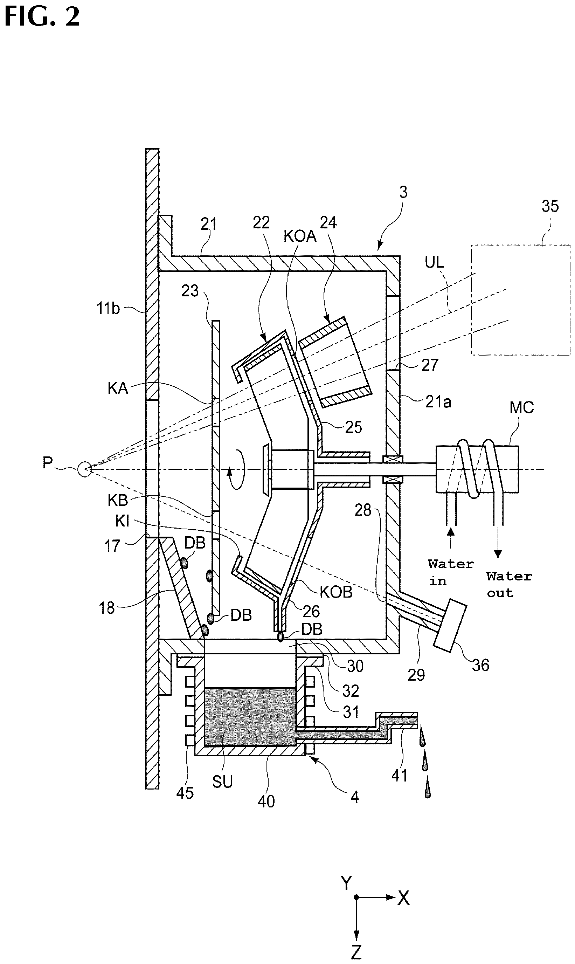

The EUV light source apparatus 1 includes a light source section 2, a debris capture section 3, and a debris storage and drainage section 4 (see FIG. 2). FIG. 2 is a side cross-sectional view illustrating the details of the debris capture section 3. The light source section 2 generates EUV light by the LDP method. The debris capture section 3 is a debris mitigation device that captures the debris scattered along with the EUV light emitted from the light source section 2. The debris storage and drainage section 4 stores the debris generated at the light source section 2 and the debris captured by the debris capture section 3.

### Configuration of light source section

The light source section 2 is provided with a chamber 11 that separates the plasma P generated inside the chamber 11 from the outside. The chamber 11 forms a plasma generation chamber that accommodates the light source section 2 in which the plasma P is generated. The chamber 11 is a vacuum enclosure made of a rigid body, e.g., metal, and its interior is maintained in a reduced-pressure atmosphere below a predetermined pressure by a vacuum pump, which is not shown in the figure, in order to generate discharges successfully to heat and excite the plasma raw materials SA and SB, and to suppress the attenuation of EUV light.

The light source section 2 is provided with a pair of discharge electrodes EA and EB. The discharge electrodes EA and EB are each a disc-shaped member having the same shape and size. For example, the discharge electrode EA is used as a cathode and the discharge electrode EB is used as an anode. The discharge electrodes EA and EB are formed from a high-melting-point metal such as molybdenum (Mo), tungsten (W), or tantalum (Ta). The discharge electrodes EA and EB are disposed apart from each other, and the circumferential edge portions of the discharge electrodes EA and EB are in close proximity to each other. The plasma P is generated in a discharge region D that is located in a gap between the discharge electrodes EA and EB, in which the circumferential edge portions of the discharge electrodes EA and EB come closest to each other.

The chamber 11 includes a container CA in which the liquid-phase plasma raw material SA is stored and a container CB in which the liquid-phase plasma raw material SB is stored. The containers CA and CB are supplied with heated, liquid-phase plasma raw materials SA and SB, respectively. The liquid-phase plasma raw materials SA and SB are, for example, tin (Sn); however, they may also be lithium (Li).

The container CA stores the plasma raw material SA such that the lower part of the discharge electrode EA is immersed in the liquid-phase plasma raw material SA. The container CB stores the plasma raw material SB such that the lower part of the discharge electrode EB is immersed in the liquid-phase plasma raw material SB. Hence, the liquid-phase plasma raw materials SA and SB adhere to the lower parts of the discharge electrodes EA and EB, respectively. The liquid-phase plasma raw materials SA and SB, which have adhered to the lower parts of the discharge electrodes EA and EB, are transported to the discharge region D where the plasma P is generated when the discharge electrodes EA and EB rotate.

The discharge electrode EA is coupled to a rotation shaft JA of a motor MA and rotates around an axis of the discharge electrode EA. The discharge electrode EB is coupled to a rotation shaft JB of a motor MB and rotates around an axis of the discharge electrode EB. The motors MA and MB are disposed outside the chamber 11, and have their rotation shafts JA and JB extending from the outside to the inside of the chamber 11, respectively. The gap between the rotation shaft JA and a wall of the chamber 11 is sealed with a seal member PA, and the gap between the rotation shaft JB and a wall of the chamber 11 is sealed with a seal member PB. The seal members PA and PB are, for example, mechanical seals. The seal members PA and PB rotatably support the rotation shafts JA and JB respectively while maintaining a reduced-pressure atmosphere in the chamber 11.

The EUV light source apparatus 1 further includes a controller 12, a pulse power supply unit 13, a laser source (energy beam irradiation device) 14, and a movable mirror 16. The controller 12, the pulse power supply unit 13, the laser source 14, and the movable mirror 16 are mounted outside the chamber 11. The controller 12 controls the operation of each section of the EUV light source apparatus 1, as will be described below. For example, the controller 12 controls the rotation drive of the motors MA and MB to rotate the discharge electrodes EA and EB at a predetermined rotation speed. The controller 12 also controls the operation of the pulse power supply unit 13, the irradiation timing of the laser beam LB from the laser source 14, and the like.

The containers CA and CB, which are located inside the chamber 11, are connected to two power feed lines QA and QB extending from the pulse power supply unit 13 and passing through feedthroughs FA and FB, respectively. The feedthroughs FA and FB are seal members that are embedded in the walls of the chamber 11 to maintain a reduced-pressure atmosphere in the chamber 11. The containers CA and CB are formed from conductive materials, and the plasma raw materials SA and SB stored inside the containers CA and CB are also conductive materials such as tin. The lower parts of the discharge electrodes EA and EB are immersed in the plasma raw materials SA and SB contained inside the containers CA and CB, respectively. Hence, when the pulse power supply unit 13 supplies the containers CA and CB with pulse power, the pulse power is supplied to the discharge electrodes EA and EB through the plasma raw materials SA and SB, respectively.

The pulse power supply unit 13 supplies the discharge electrodes EA and EB with the pulse power to generate an electric discharge in the discharge region D. The plasma raw materials SA and SB that have been transported to the discharge region D by the rotation of the respective discharge electrodes EA and EB are heated and excited by the current flowing between the discharge electrodes EA and EB during discharge, thereby generating the plasma P that emits EUV light.

The laser source 14 irradiates the plasma raw material SA that has adhered to the discharge electrode EA and has been transported to the discharge region D with the energy beam to vaporize the plasma raw material SA. The laser source 14 is, for example, a Nd:YVO₄ (Neodymium-doped Yttrium Orthovanadate) laser system. Then, the laser source 14 emits the laser beam LB in the infrared region having a wavelength of 1064 nm. However, the energy beam irradiation device may be a device that emits an energy beam other than the laser beam LB, provided that it enables vaporization of the plasma raw material SA.

The laser beam LB emitted from the laser source 14 is guided to the movable mirror 16 via a condensing means including, for example, a condensing lens 15. The condensing means adjusts a spot diameter of the laser beam LB at a laser beam irradiation position of the discharge electrode EA. The condensing lens 15 and the movable mirror 16 are disposed outside the chamber 11.

The laser beam LB that has been focused by the condensing lens 15 is reflected by the movable mirror 16, passes through a transparent window 20 provided in a side wall 11a of the chamber 11, and impinges onto the circumferential edge portion of the discharge electrode EA near the discharge region D. The position at which the laser beam LB impinges onto the discharge electrode EA is adjusted by adjusting the posture of the movable mirror 16. The adjustment of the posture of the movable mirror 16 may be manually performed by an operator, or the controller 12 may control the posture of the movable mirror 16 based on the intensity information of EUV light from a monitoring device 36 to be described below. In this case, the movable mirror 16 is driven by a movable mirror drive unit, which is not shown in the figure.

In order to facilitate the irradiation of the laser beam LB onto the circumferential edge portion of the discharge electrode EA near the discharge region D, the axes of the discharge electrodes EA and EB are not aligned in parallel. The spacing between the rotation shafts JA and JB is narrower on the side of the motor MA and MB, and is wider on the side of the discharge electrodes EA and EB. This configuration allows the facing surfaces of the discharge electrodes EA and EB to be placed closer to each other while the opposite side of the facing surfaces of the discharge electrodes EA and EB is retreated from the irradiation path of the laser beam LB, making it easier to irradiate the circumferential edge portion of the discharge electrode EA near the discharge region D with the laser beam LB.

The discharge electrode EB is disposed between the discharge electrode EA and the movable mirror 16. The laser beam LB that has been reflected by the movable mirror 16 passes near the outer circumferential surface of the discharge electrode EB and then reaches the outer circumferential surface of the discharge electrode EA. At this time, to prevent the laser beam LB from being blocked by the discharge electrode EB, the discharge electrode EB is retreated to the direction of the motor MB side (left side of FIG. 1) from the discharge electrode EA. The liquid-phase plasma raw material SA that has adhered to the outer circumferential surface of the discharge electrode EA near the discharge region D is vaporized by the laser beam LB irradiation. The vaporized plasma raw material is supplied to the discharge region D as gas-phase plasma raw material SA.

The pulse power supply unit 13 supplies the discharge electrodes EA and EB with power to generate the plasma P in the discharge region D (to convert the gas-phase plasma raw material SA into plasma). When the gas-phase plasma raw material SA is supplied to the discharge region D by the laser beam LB irradiation, the discharge occurs between the discharge electrodes EA and EB in the discharge region D. The discharge occurring between the discharge electrodes EA and EB heats and excites the gas-phase plasma raw material SA in the discharge region D with its electric current, generating the plasma P. The generated plasma P emits EUV light, and the EUV light enters the debris capture section 3 through a first window 17, which is a through-hole provided in a side wall 11 b of the chamber 11.

### Debris capture section

The debris capture section 3 includes a connection chamber 21 disposed on the side wall 11 b of the chamber 11. The connection chamber 21 is a vacuum enclosure made of a rigid body, e.g., metal, and its interior is maintained in a reduced-pressure atmosphere below a predetermined pressure to suppress the attenuation of the EUV light, as similar to the chamber 11. The connection chamber 21 is connected between the chamber 11 and the utilization apparatus 35 (see FIG. 2).

The internal space of the connection chamber 21 communicates with the chamber 11 through the first window 17. The connection chamber 21 includes a second window 27 as a light extraction section that guides EUV light coming from the first window 17 to the utilization apparatus 35 (e.g., mask inspection system). The second window 27 is a through-hole of a predetermined shape formed in a side wall 21a of the connection chamber 21.

Meanwhile, the plasma P releases debris DB (see FIG. 2) at high speed in various directions along with EUV light. The debris DB includes particles of tin, which are the plasma raw materials SA and SB, and particles of material of the discharge electrodes EA and EB, which are sputtered with the generation of plasma P. The debris DB obtains a large amount of kinetic energy through the contraction and expansion process of the plasma P. In other words, the debris DB generated from the plasma P contains ions, neutral particles, and electrons moving at high speed. When such debris DB reaches the utilization apparatus 35, it may damage or contaminate reflective coatings of optical elements disposed in the utilization apparatus 35, degrading its performance.

Hence, the debris capture section 3 includes a rotary foil trap 22 (equivalent to the foil trap of the present embodiment) and a fixed foil trap 24 to prevent the debris DB from entering the utilization apparatus 35. The rotary foil trap 22 and the fixed foil trap 24 are disposed inside the connection chamber 21. The fixed foil trap 24 is mounted between the rotary foil trap 22 and the utilization apparatus 35 on the optical path of the EUV light traveling from the connection chamber 21 to the utilization apparatus 35. The one debris capture section 3 may be provided with both the rotary foil trap 22 and the fixed foil trap 24, or either one of them.

The rotary foil trap 22 is a trap that collects debris by rotating the foils to cause the foils to collide with the debris. The rotary foil trap 22 is, for example, driven by a motor MC mounted outside the connection chamber 21.

The fixed foil trap 24 has a plurality of foils arranged in a fixed position, and a gas such as helium or argon is made to be localized around the foils to form a region where its pressure is relatively high. Debris entering this region degreases in its velocity, changes its traveling direction, and is collected. The debris collected in each trap is stored in the debris storage vessel 40, which will be described later.

### Debris storage and drainage section

The debris storage and drainage section 4 includes a debris storage vessel 40 that temporarily stores the debris DB, and a debris drainage section 41 through which the debris that has been stored in the debris storage vessel 40 drains away to the outside. The debris storage vessel 40 is disposed outside the connection chamber 21 and is attached to the connection chamber 21. The debris storage vessel 40 stores stored material SU including the debris DB and waste raw materials.

The connection chamber 21 has a through-hole 30 in the bottom wall thereof, through which the internal space of the debris storage vessel 40 communicates with the internal space of the connection chamber 21. The debris storage vessel 40 is provided with a flange 31 at its top. The debris storage vessel 40 has an opening that is surrounded by the flange 31 and that is aligned with the through-hole 30 in the connection chamber 21. The flange 31 is fixed to the bottom wall of the connection chamber 21 with screws, for example, to attach the debris storage vessel 40 to the connection chamber 21. The gap between the flange 31 and the bottom wall of the connection chamber 21 is sealed by a gasket 32. A heat shield plate 23 is disposed above the through-hole 30 in an upright position. The outlet of a drain hole 26 is located above the through-hole 30. At this time, the debris storage vessel 40 is located at a position where the debris DB falls from the heat shield plate 23 and the drain hole 26.

The waste raw materials that have been drained away from a cover 25 through the drain hole 26 falls in the direction of gravity, and is then stored in the debris storage vessel 40, which is located below the connection chamber 21 (lower side in Fig. 2). In contrast, when part of the debris DB, which is released from the plasma P in various directions, enters the connection chamber 21 through the window 17 of the chamber 11, it deposits on the surface of the heat shield plate 23 facing the window 17. The debris DB deposited on the heat shield plate 23 melts due to radiation from the plasma P. When the melted debris reaches a certain amount, it turns into a droplet and moves downward from the heat shield plate 23 by gravity. The debris DB that has moved to the lower side of the heat shield plate 23 is detached from the heat shield plate 23, falls below the connection chamber 21, and thus is stored in the debris storage vessel 40.

Hence, the heat shield plate 23 not only serves to prevent overheating of the rotary foil trap 22 by restricting EUV radiation from the plasma P to the rotary foil trap 22 and to allow a portion of EUV light emitted from the plasma P to be extracted through an opening KA, but also serves to reduce the load on the rotary foil trap 22 by minimizing the amount of debris DB traveling toward the rotary foil trap 22 as much as possible.

In addition, in the LDP-based EUV light source apparatus 1, part of the plasma raw materials (tin) SA and SB, which is supplied to the discharge section such as discharge electrodes EA and EB, may leak. For example, part of the plasma raw materials SA and SB may leak from the containers CA and CB. The leaked plasma raw materials SA and SB do not contribute to generation of the plasma P, thus becoming waste raw materials. The plasma raw materials SA and SB leaked from the above-mentioned discharge section are collected by an encircling member, which is not shown in the figure.

In order to guide the plasma raw materials SA and SB that have been collected as waste raw materials by the encircling member to the debris storage vessel 40, the connection chamber 21 is provided with a receiving plate (shovel) 18 therein. The receiving plate 18 is supported in an inclined position and extends from the window 17 to the through-hole 30. The receiving plate 18 is heated by a heating means (heater), which is not shown in the figure, to allow the plasma raw materials SA and SB collected as waste raw materials to maintain the melting point or higher on the receiving plate 18. The plasma raw materials SA and SB collected as waste raw materials by the encircling member and part of the debris DB that has entered the connection chamber 21 are guided to the receiving plate 18, thus falling into the debris storage vessel 40.

Here, since most of the debris DB is tin and the waste materials is also tin, the debris storage vessel 40 may be referred to as a tin collection vessel (Tin Dump). The debris storage vessel 40 is provided with a storage vessel heater 45 that surrounds and heats the debris storage vessel 40. The heating means may be embedded in the debris storage vessel 40 itself. During the operation of the EUV light source apparatus 1, the storage vessel heater 45 is supplied with power to allow the inside of the debris storage vessel to be heated at or above the melting point of tin, turning the tin accumulated inside the debris storage vessel 40 into a liquid-phase.

The reason why the tin inside the debris storage vessel 40 is in a liquid-phase is that when the debris DB accumulated inside the debris storage vessel 40 solidifies, the accumulation materials at a position where the debris DB tends to fall grow just like a stalagmite in a limestone cave. When the accumulation materials of the debris DB grow like a stalagmite, for example, the drain hole 26 of the cover 25 may be blocked by the DB debris, thus the debris DB accumulates in the cover 25. In this case, at least part of the debris DB accumulated in the cover 25 may come into contact with the rotary foil trap 22, interfering with the rotation of the rotary foil trap 22 or damaging the rotary foil trap 22. Alternatively, part of exit side openings KOA and KOB provided in the cover 25 may be blocked by the debris DB accumulated in the cover 25, blocking part of the EUV light passing through the exit side openings KOA and KOB. Hence, by turning tin, which is the stored material in the debris storage vessel 40, into a liquid-phase, this makes it possible to flatten the tin in the debris storage vessel 40, storing the tin in the debris storage vessel 40 while preventing a growth of tin like a stalagmite.

A monitoring device 36 that monitors EUV light is located outside the connection chamber 21. The monitoring device 36 is a detector that detects EUV light or a measuring instrument that measures the intensity of EUV light. The wall of the connection chamber 21 has an EUV light guide hole 28 that is a through-hole through which EUV light passes. A guide pipe 29 is provided between the EUV light guide hole 28 and the monitoring device 36, through which the EUV light passes without leaking outside the connection chamber 21.

The heat shield plate 23 is provided with an opening KB having any shape (e.g., circular) at a different position from the opening KA to extract part of the EUV light emitted from the plasma P. The monitoring device 36, the EUV light guide hole 28, and the guide pipe 29 are disposed along an extended line of the straight line connecting the plasma P and the center of the opening KB. Thus, part of the EUV light emitted from the plasma P passes through, in sequence, the window 17 of the chamber 11, the opening KB of the heat shield plate 23, the incident side opening KI of the cover 25, the space between the plurality of foils of the rotary foil trap 22, the exit side opening KOB of the cover 25, the EUV light guide hole 28 in the wall of the connection chamber 21, and the inside of the guide pipe 29, to reach the monitoring device 36. In this way, the EUV light can be monitored by the monitoring device 36.

### Configuration of debris storage and drainage section

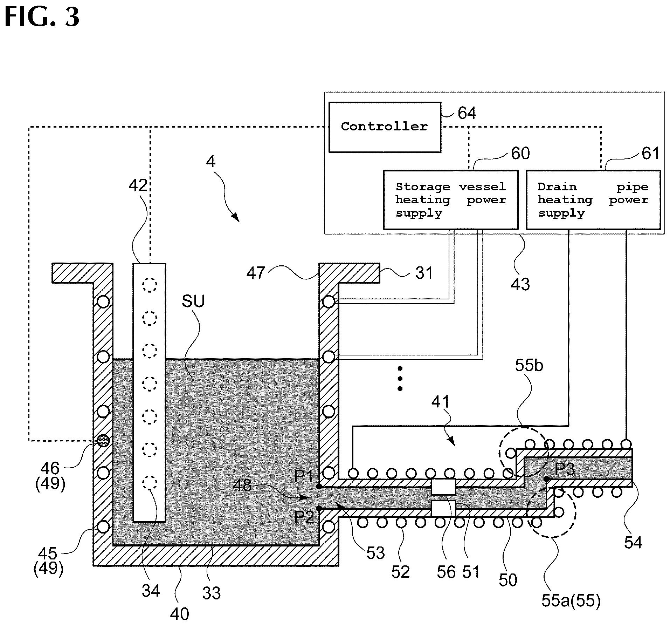

FIG. 3 is a schematic cross-sectional view illustrating an example of the configuration of a debris storage and drainage section. The debris storage and drainage section is a mechanism that temporarily stores debris, waste materials, etc. and drains the stored material SU outside the EUV light source apparatus 1. In the present embodiment, the debris storage and drainage section corresponds to a storage and drainage mechanism. The debris storage and drainage section 4 includes a debris storage vessel 40, a debris drainage section 41, a level sensor 42, and a temperature control system 43.

The debris storage vessel 40 is a vessel that stores the stored material SU including debris during the operation of the EUV light source apparatus 1. The debris storage and drainage section 4 further includes the storage vessel heater 45 and a storage vessel temperature sensor 46. In the present embodiment, the temperature of the debris storage vessel 40 is suitably controlled, using the storage vessel heater 45 and the storage vessel temperature sensor 46, by the temperature control system 43, which will be described later.

The debris storage vessel 40 stores the stored material SU at a temperature at which it is in a liquid-phase state. In the present embodiment, the debris storage vessel 40 corresponds to a storage vessel. The stored material SU (debris and waste materials) stored in the debris storage vessel 40 remain in a liquid-phase state at least during the operation of the EUV light source apparatus 1. Since the stored material is mostly tin, the debris storage vessel 40 is heated so that the temperature of the stored material SU stored thereinside reaches the melting point of tin (approximately 232°C) or higher. Hence, the stored material SU includes the metal of the plasma raw material and is stored as liquid metal. The debris storage vessel 40 is made of a material capable of retaining the stored material SU at a temperature at which it is in a liquid-phase state. The material of the debris storage vessel 40 is typically stainless steel, but is not limited to this material.

In the present embodiment, the debris storage vessel 40 is a concave vessel, and includes the flange 31 described above, an upper opening 47, and a connection opening 48. The upper opening 47 is an opening located on the upper side of the debris storage vessel 40. The flange 31 is located around the upper opening 47 and protrudes outward from the side surface of the debris storage vessel 40. The connection opening 48 is a through-hole provided in the side surface of the debris storage vessel 40 to which a drain pipe 50, which will be described below, is connected.

The debris storage vessel 40 is mounted to the bottom wall of the connection chamber 21 in a state in which the upper opening 47 is positioned to overlap the through-hole 30 provided in the bottom of the connection chamber 21 by, for example, fixing the flange 31 to the bottom thereof using screws. Then, a seal member (gasket 32) is provided between the flange 31 and the connection chamber 21 to maintain a vacuum state. This allows the inside of the debris storage vessel 40 to have the same pressure as the connection chamber 21.

The debris storage vessel 40 is configured as a quadrangular pillar-shaped vessel, for example. In this case, as shown in FIG. 3, the debris storage vessel 40 has a wall (in this case, sidewall) provided with holeshaped mounting sections 49 for the storage vessel heater 45 and the storage vessel temperature sensor 46 to be embedded and mounted therein. Thus, by embedding the storage vessel heater 45 and the storage vessel temperature sensor 46 in the wall of the vessel, this makes it possible to perform the temperature control of the debris storage vessel 40 accurately and efficiently. In addition, the shape of the debris storage vessel 40 and the configuration of the mounting sections 49 are not limited to those described above. For example, the debris storage vessel 40 may be a cylindrical-shape vessel. In this case, the storage vessel heater 45 may be provided to surround the perimeter of the vessel.

The storage vessel heater 45 is an element that heats the debris storage vessel 40 and serves as means of heating the storage vessel. As described above, the storage vessel heater 45 is embedded in a part of the wall that surrounds the interior of the vessel in which the stored material SU is stored. Examples of the storage vessel heater 45 include a cartridge heater having a heating element covered with a sheath (metal pipe). The sheath of the cartridge heater is inserted into the mounting section 49 with its end sealed and is retained in the debris storage vessel 40. Examples of the heating element of the cartridge heater include a nichrome wire. In this case, supplying an electric current to the nichrome wire enables the heating of the debris storage vessel 40.

The storage vessel temperature sensor 46 is a sensor that measures the temperature of the debris storage vessel 40. The storage vessel temperature sensor 46 uses, for example, a resistance temperature detector (RTD). The resistance temperature detector utilizes the properties of metals or metal oxides that their electrical resistance changes with a change in temperature, and measures their electrical resistance to determine its temperature. Various metals can be adopted for the resistance temperature detector; however, for example, platinum (Pt100) is adopted because of its stable properties and easy availability. Although sensors other than the resistance temperature detector can also be used as the storage vessel temperature sensor 46, the resistance temperature detector enables high-precision measurement, and has excellent stability and reproducibility. The resistance temperature sensor is also relatively insensitive to electrical noise, making it suitable for use in the EUV light source apparatus 1, which is provided with a discharge portion that generates electrical noise.

In the present embodiment, the storage vessel temperature sensor 46 is embedded in the wall of the debris storage vessel 40. To make the storage vessel temperature sensor 46 to be readily embedded, a sheath-type resistance temperature detector sensor can be used, for example. In a sheath-type resistance temperature detector sensor, a resistance element and a conductor connected thereto are inserted into a sheath (metal pipe), and an insulating material (magnesium oxide) is filled inside the sheath to form a single piece of the sensor. The sheath-type resistance temperature detector sensor is inserted into the mounting section 49 for the storage vessel temperature sensor 46 with the end of the sheath sealed, and is retained in the debris storage vessel 40. Furthermore, the specific configuration of the storage vessel temperature sensor 46 is not limited to that of the present embodiment. The storage vessel temperature sensor 46 that is capable of measuring temperatures, for example, in a temperature range in which the stored material SU changes from a solid-phase state to a liquid-phase state, and in a temperature range in which a liquid-phase state is maintained, may be suitably used.

The debris drainage section 41 is a block that drains the stored material SU including debris, and includes the drain pipe 50, an aperture 51, and a drain pipe heater 52. The debris drainage section 41 uses the drain pipe heater 52 to suitably control the temperature of the drain pipe 50 by the temperature control system 43, which will be described later.

The drain pipe 50, which is a pipe-shaped structure that communicates with the interior of the debris storage vessel 40, drains the stored material SU stored in the debris storage vessel 40. The drain pipe 50 has an inlet 53 through which the stored material SU flows in and an outlet 54 through which the stored material SU drains away. The tubular space from the inlet 53 to the outlet 54 is a channel through which the stored material SU drains away. The drain pipe 50, similar to the debris storage vessel 40, is composed of a material capable of holding the stored material SU at a temperature at which it is in a liquid-phase state. The material of the drain pipe 50 is typically stainless steel, but is not limited to this.

In the example shown in FIG. 3, the drain pipe 50 is provided as a whole to protrude from the side of the debris storage vessel 40. Specifically, the inlet 53 of the drain pipe 50 is connected to the connection opening 48 provided in the side surface of the debris storage vessel 40. In this way, the channel of the drain pipe 50 is spatially connected to the interior of the debris storage vessel 40. Hence, the stored material SU

(debris and waste materials) that is temporarily stored in the debris storage vessel 40, and that is maintained in a liquid-phase state, enters the drain pipe 50 through the inlet 53. By guiding the stored material SU entering through the inlet 53 to the outlet 54 while maintaining a liquid-phase state, this enables the drainage material SW to be drained away to the outside. The drain pipe 50 may be provided in a manner that the inlet 53 protrudes inside the debris storage vessel 40.

The drain pipe 50 is provided with a bent portion 55 at which the main body of the drain pipe 50 is bent. Specifically, the bent portion 55 is provided to be bent such that at least part of the lower end of the inner surface of the channel of the drain pipe 50 is higher than the upper end of the inlet 53. The lower end of the inner surface of the channel is the lowest portion on each location of the channel configured inside the drain pipe 50. Liquid flowing through the drain pipe 50 flows through the lower end of the inner surface of the channel, regardless of the amount of flow. The upper end of the inlet 53 is the highest portion at the inlet 53. The lowest portion in inlet 53 is the lower end of the inlet 53. In the following, the upper end and the lower end of the inlet 53 will be referred to as P1 and P2, respectively.

In FIG. 3, two bent portions 55a and 55b that bend the drain pipe 50 at right angle are provided. The drain pipe 50 protruding horizontally from the debris storage vessel 40 is bent vertically upward at the bent portion 55a, and is bent horizontally at the bent portion 55b. In this case, the lower end P3 of the inner surface of the channel, which is located beyond the bent portion 55b when viewed from the inlet 53, is higher than the upper end P1 of the inlet 53. As a result, the channel from the inlet 53 through the bent portion 55a to the lower end P3 of the bent portion 55b is always filled with the stored material SU.

As shown in FIG. 3, the drain pipe 50 is connected to the debris storage vessel 40 such that the lower end P2 of the inlet 53 is positioned to be higher than the bottom 33 of the interior of the debris storage vessel 40 by a predetermined distance. In the present embodiment, the position of the inlet 53 is the same as the position of the connection opening 48 provided on the side surface of the debris storage vessel 40. In this case, it can be understood that the connection opening 48 is provided at a position that is higher by a predetermined distance from the bottom 33 of the debris storage vessel 40. As a result, the stored material SU located above the bottom 33 of the debris storage vessel 40 by a certain distance flows into the drain pipe 50.

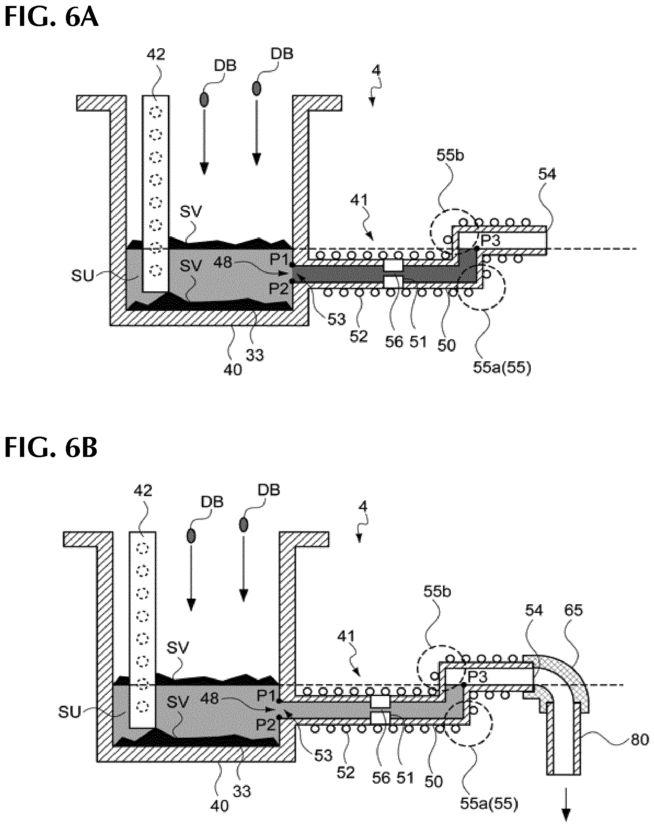

The aperture 51 is provided in the channel of the drain pipe 50 and constitutes an aperture channel 56 that has a smaller cross section than the channel of the drain pipe 50. In other words, the aperture 51 is an element that serves to reduce the cross section of the channel by introducing the aperture channel 56 into the channel constituted by the drain pipe 50. Examples of the aperture 51 include an element with a through-hole that has a smaller cross section than the channel of the drain pipe 50. This through-hole serves as the aperture channel 56. The location of the through-hole is typically set in the center of the cross section of the channel of the drain pipe 50. The aperture 51 is located between the inlet 53 and the bent portion 55 of the drain pipe 50. Hence, the aperture channel of the aperture 51 is always filled with the stored material SU. The role of the aperture 51 will be described in detail with reference to the drawings including FIGS. 6A and 6B.

The drain pipe heater 52 heats the drain pipe 50 to change the temperature of the drain pipe 50. For example, operating the drain pipe heater 52 makes the temperature of the drain pipe 50 higher than room temperature. The temperature of the drain pipe 50 can be adjusted by controlling the output of the drain pipe heater 52. Stopping the operation of the drain pipe heater 52 allows the temperature of the drain pipe 50 to drop and return to room temperature. In this way, the drain pipe heater 52 acts as a temperature control element that adjusts the temperature of the drain pipe 50.

For example, in order to allow the stored material SU stored in the debris storage vessel 40 to drain away to the outside through the channel of the drain pipe 50, it is necessary to raise the temperature of the stored material SU flowing through the channel of the drain pipe 50 to a temperature at which the stored material SU changes in a liquid-phase state (above the melting point of tin). Hence, in the present embodiment, the drain pipe heater 52 is used to heat the drain pipe 50.

Examples of the drain pipe heater 52 include a fine-tube heater. The fine-tube heater is a thin-wire element consisting of an electric heating wire (typically a nichrome wire), which is a heating element, wrapped in a bendable outer film. The fine-tube heater is wound around the entire drain pipe 50, for example. Other specific configurations of the drain pipe heater 52 are not limited to that of the embodiment described above; however, any heater element capable of properly heating the drain pipe 50 may be used. A drain pipe temperature sensor or the like may also be provided to measure the temperature of the drain pipe 50.

The level sensor 42 is provided inside the debris storage vessel 40, and is used to detect the liquid surface level of the stored material SU temporarily stored in the debris storage vessel 40 and stored in a liquid-phase state. The liquid surface level of the stored material SU is an indicator of how much the stored material SU has accumulated in the vessel, and represents the amount of stored material SU in the debris storage vessel 40. Hence, the level sensor 42 can be understood to be a volume sensor that detects the amount of the stored material SU in the debris storage vessel 40.

Examples of the level sensor 42 include a multi-point type thermocouple. FIG. 3 schematically illustrates a thermocouple type level sensor with multiple measurement points 34 along the vertical direction. This level sensor is capable of measuring the change in temperature at each measurement point. Hence, for example, when the measurement point 34 is immersed below the liquid surface, the temperature increases; and when the measurement point 34 is located above the liquid surface, the temperature decreases. In this way, the position of the measurement point 34 at which the temperature changes is detected as the liquid surface level.

The specific configuration of the level sensor 42 is not limited to that of the embodiment described above. Examples of the level sensor 42 may include a sensor that detects the surface position by detecting the electric current flowing through the stored material SU, which is liquid metal. Examples of the level sensor 42 may also include a distance measurement sensor using a laser beam or the like, and a sensor capable of measuring the amount of the stored material SU.

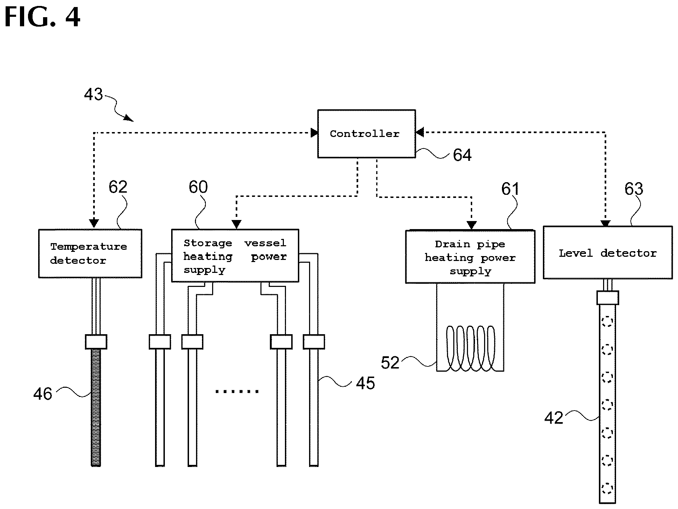

FIG. 4 is a block diagram illustrating an example of the temperature control system 43. The temperature control system 43 controls the temperature of respective parts of the debris storage and drainage section 4. The temperature control system 43 includes a storage vessel heating power supply 60, a drain pipe heating power supply 61, a temperature detector 62, a level detector 63, and a controller 64.

The storage vessel heating power supply 60 is an electric power source that individually supplies power for heating to each of a plurality of storage vessel heaters 45 (cartridge heaters) provided in the debris storage vessel 40. The storage vessel heating power supply 60 is connected to the individual storage vessel heater 45 via a pair of power wires. The drain pipe heating power supply 61 is a power source that supplies power for heating to the drain pipe heater 52 provided in the drain pipe 50. A pair of power wires extending from the drain pipe heating power supply 61 is connected to the respective ends of the drain pipe heater 52, which is a fine-tube heater wound around the drain pipe 50.

The temperature detector 62 supplies power to the storage vessel temperature sensor 46 (resistance temperature detector) and detects temperature information from the sensor (detection of electrical resistance values). In addition, the temperature detector 62 transmits the temperature information from the storage vessel temperature sensor 46 to the controller 64. The level detector 63 supplies power to the level sensor 42 (multi-point type thermocouple) and detects the liquid surface level of the stored material SU from the sensor (position of the measurement point 34). In addition, the level detector 63 transmits the liquid surface level information from the level sensor 42 to the controller 64. The temperature detector 62 and the level detector 63 are configured, for example, as a communication unit that communicates with the controller 64. Alternatively, they may be configured as dedicated devices to drive their respective sensors.

The controller 64 allows the storage vessel heater 45 to operate to control the temperature of the debris storage vessel 40, and also allows the drain pipe heater 52 to operate to control the temperature of the drain pipe 50. The controller 64 is an arithmetic unit having a hardware configuration necessary for computers including a CPU and memory (RAM, ROM). The CPU loads a predetermined control program into RAM and executes it to perform processes such as switching the drainage and storage of the stored material.

First, the temperature control of the debris storage vessel 40 is described. The controller 64 controls the storage vessel heating power supply 60, thereby controlling the amount of power supplied to the storage vessel heater 45 and ON/OFF of power supplied thereto. As described above, for example, during the operation of the EUV light source apparatus 1, the storage vessel heater 45 is set to be ON, and the debris storage vessel 40 is heated to make the stored material SU in the debris storage vessel 40 to be in a liquid-phase state. At this time, based on the temperature information measured by the storage vessel temperature sensor 46, the amount of power supplied to the storage vessel heater 45 is controlled to maintain the temperature at which the stored material SU is in the liquid-phase state. This makes it possible to stably store the stored material SU in a liquid-phase state.

Next, the temperature control of the drain pipe 50 is described. The controller 64 controls the drain pipe heating power supply 61, thereby controlling the amount of power supplied to the drain pipe heater 52 (fine-tube heater) and ON/OFF of power supplied thereto. Specifically, the controller 64 controls the drain pipe heater 52 to switch the temperature of the drain pipe 50 in a manner that the stored material SU in the drain pipe 50 is in either a liquid-phase state or a solid-phase state. The process of switching the temperature is performed as needed, for example, during the operation of the EUV light source apparatus 1. In the present embodiment, the collaboration of the controller 64 with the drain pipe heating power supply 61 serves as the temperature controller.

For example, at temperatures at which the stored material SU is in a liquid-phase state, the stored material SU flows in the channel, thus enabling a drainage operation for draining the stored material SU. Therefore, the controller 64 controls the temperature of the drain pipe 50 to allow the stored material SU to be in the liquid-phase state when performing the drainage operation. In contrast, at the temperature atwhich the stored material SU is in a solid-phase state, the stored material SU solidifies in the channel, thus enabling a storage operation for storing the stored material SU without draining the stored material SU. Therefore, the controller 64 controls the temperature of the drain pipe 50 to allow the stored material SU to be in a solid-phase state when performing the storage operation.

In the present embodiment, the controller 64 controls the drain pipe heater 52 based on the detection result of the level sensor 42. In other words, the controller 64 allows the drainage operation and storage operations to be switched and performed according to the level of the stored material SU accumulated in the debris storage vessel 40. This configuration enables the control in which, for example, the stored material SU in the debris storage vessel 40 drains away to prevent the debris storage vessel 40 from overflowing when the stored material SU therein reaches a certain level. The specific operation of the controller 64 will be described in detail later.

### Role of drain pipe and aperture

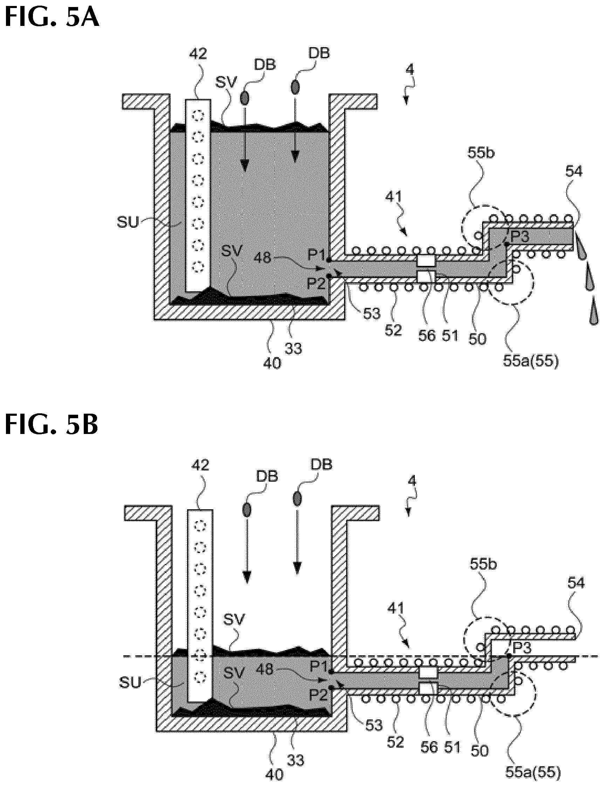

Here, the role of the drain pipe 50 in the drainage operation for draining the stored material SU is described. FIG. 5A is a schematic view for describing the role of the drain pipe 50 and illustrating a state of the debris storage vessel 40 and the drain pipe 50 during drainage operation. FIG. 5B is a schematic view for describing the role of the drain pipe 50 and illustrating a state in which the stored material stops draining away after the state shown in FIG. 5A. In Fig. 5A and the following, the storage vessel heater 45, the storage vessel temperature sensor 46, the storage vessel heating power supply 60, and the temperature control system 43 (controller 64, etc.) are omitted to be illustrated as appropriate.

In FIG. 5A, the stored material SU in the debris storage vessel 40 is in a liquid-phase state and its liquid surface level is at a relatively high level. The drain pipe 50 is heated, and the stored material SU in the channel of the drain pipe 50 is also in a liquid-phase state. Hence, the debris storage and drainage section 4 is in a state in which the drainage operation of draining the stored material SU can be performed.

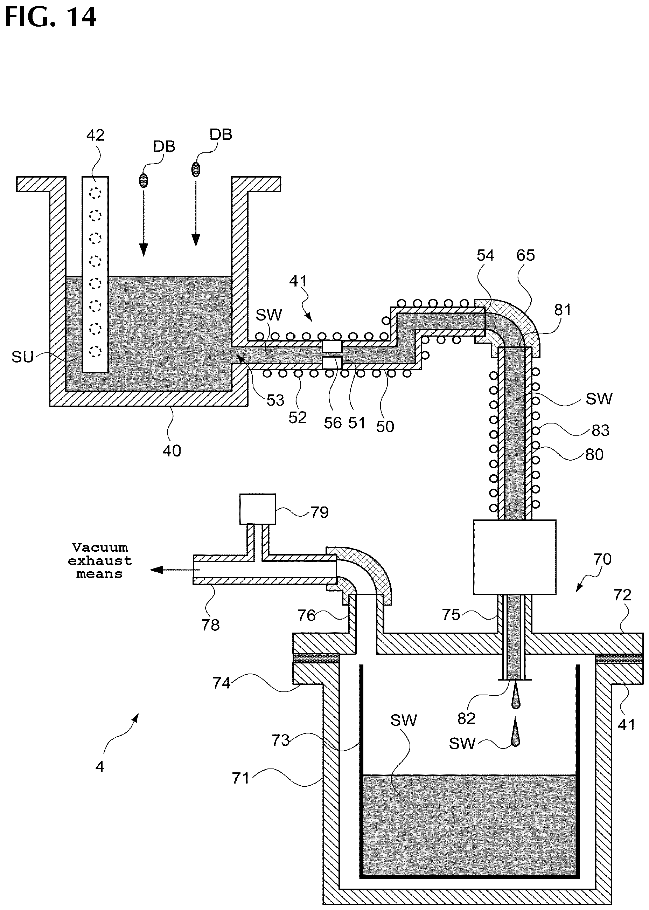

The drainage operation is performed, for example, when the pressure at the outlet 54 is less than the pressure inside the debris storage vessel 40. In this case, the stored material SU in a liquid-phase state is drained in a manner that it is sucked out to the outlet 54. The pressure at the outlet 54 can be reduced, for example, by reducing the pressure in a debris collection vessel 70 (see FIG. 14), which is connected to the outlet 54. This enables the stored material SU to be reliably drained away. The drainage operation may be performed, for example, in a state in which the pressure at the outlet 54 substantially matches the pressure inside the debris storage vessel 40. In this case, the stored material SU in a liquid-phase state drains away from the outlet 54 by its own weight. The pressure at the outlet 54 may be set to a pressure level at which the stored material SU is drained away. As long as being a pressure at which the stored material SU can be drained away, the pressure at the outlet 54 may be set, for example, higher than the pressure inside the debris storage vessel 40.

Once the drainage operation is started, the liquid surface level in the debris storage vessel 40 gradually decreases. As described above, providing the bent portions 55a and 55b in the drain pipe 50 creates a step in the channel of the drain pipe 50. As the liquid surface level of the stored material SU continues to decrease, at a certain point, the liquid surface level thereof matches the lower end of the outlet 54 (here P3) as shown in FIG. 5B. In this state, the stored material SU located between the bent portion 55b and the outlet 54 is approximately drained away. Since the stored material SU located between the inlet 53 and the bent portion 55a cannot exceed the step on the channel, the stored material SU automatically stops draining away from the outlet 54. In addition, since the space between the inlet 53 and the bent portion 55a is filled with the stored material SU, the vacuum is ensured in the debris storage vessel. Hence, providing a bent portion 55 in the drain pipe 50 enables the drainage operation of the stored material SU to be safely stopped.

Note that the stored material SU (debris and waste materials) stored in the debris storage vessel 40 contains the plasma raw material (tin), which is the main component therein, and also impurities SV. In FIGS. 5A and 5B, the impurities SV contained in the stored material SU are schematically illustrated as black areas. The impurities SV include, for example, particulates of molybdenum (Mo), tungsten (W), or tantalum (Ta) which are produced when the discharge electrode EA is sputtered during discharge. In addition, the impurities may include, for example, reaction products resulting from the reaction between tin, which is the main component constituting the debris and waste materials, and stainless steel, which forms the debris storage vessel 40. These impurities SV are precipitated at the bottom of the debris storage vessel 40, as shown in FIG. 5A. Alternatively, the impurities may float on the liquid surface of the stored material SU. When such impurities enter the drain pipe 50, the channel of the drain pipe 50 (especially the aperture channel 56 in the aperture 51) may become blocked, making it difficult to drain the stored material SU to the outside.

In contrast, the bent portion 55 of the drain pipe 50 has a lower end (e.g., P3) of the inner surface of the channel that is set higher than the upper end P1 of the inlet 53. Thus, the liquid surface level of the stored material SU is maintained at a position higher than the upper end P1 of the inlet 53 even when the liquid surface level thereof is at its lowest. This makes it possible to avoid a situation in which the impurities SV floating on the liquid surface of the stored material SU enter the inlet 53.

Furthermore, the lower end P2 of the inlet 53 is set to be located higher by a predetermined distance from the bottom 33 of the interior of the debris storage vessel 40. The predetermined distance is set such that the impurities SV that have been precipitated on the bottom 33 of the debris storage vessel 40 do not reach the drain pipe 50 when the stored material SU drains away from the drain pipe 50. This makes it possible to avoid a situation in which the impurities SV that have been precipitated on the bottom of the stored material SU enter the inlet 53. Hence, in this embodiment, the drain pipe 50 is configured not to take in the impurities SV. This makes it possible to avoid a situation in which the channel of the drain pipe 50 is blocked and to perform the drainage operation in a stable manner.

FIG. 6A is a schematic view, to describe the role of the aperture, illustrating a state in which after the stored material SU has stopped draining away as illustrated in FIG. 5B, the stored material SU solidifies with heating the drain pipe 50 stopped. In this case, the stored material SU remaining between the inlet 53 and the bent portion 55a is in a solid-phase state. Hereinafter, the stored material SU that has been in a solid-phase state is schematically illustrated as a darker gray area than the stored material SU being in the liquid-phase state.

The stored material SU, which is constituted by debris and waste raw materials, includes liquid metal (tin) as their main component. When such stored material SU undergoes a phase change from a liquid-phase state to a solid-phase state, its volume decreases. As a result, as shown in FIG. 6A, a space (gap) is actually created due to the decrease in volume of the stored material SU in the channel of the drain pipe 50 in which the solidified stored material SU exists. Hence, the gap that is created when the stored material SU is in a solid-phase state may degrade the reduced-pressure atmosphere in the EUV light source apparatus 1 (the debris storage vessel 40).

To address this issue, the channel of the drain pipe 50 is provided with the aperture 51 to reduce the cross section of the channel. The aperture 51 is provided, as described above, between the inlet 53 and the bent portion 55a. Hence, when the stored material SU is in a liquid-phase state, the aperture 51 is completely immersed in the stored material SU, and the aperture 51 rarely comes in contact with the gap. Suppose the stored material SU is in a solid-phase state in this configuration, a gap is expected to be formed inside the drain pipe 50, mainly at the upper end of the inner surface of the channel because the stored material SU is subjected to its own weight. In contrast, the aperture channel of aperture 51, which is blocked by the stored material SU with a solid-phase state, serves as a vacuum seal valve. In other words, the aperture 51 serves as an open valve in a liquid-phase state, and a closed valve in a solid-phase state.

Furthermore, by suitably adjusting the cross section of the aperture channel 56 constituted by the aperture 51, this makes it possible to reduce the amount of vacuum leakage from the drain pipe 50 when the stored material SU is in a solidified state. According to the inventors' experiments, when the inventors investigated the amount of leakage from a helium leak check by suitably adjusting the cross-section of the channel of the aperture 51, the configuration was found to enable the pressure inside the EUV light source apparatus 1 to be maintained at a reduced-pressure atmosphere that fails to affect the operation of the EUV light source apparatus 1.

FIG. 6B is a schematic view, to describe the role of the aperture, illustrating the drainage operation with the drain pipe 50 having the outlet 54 extending downward. Here, the case in which, for example, the stored material SU is collected in a predetermined collection vessel (see FIG. 14) is considered. Since the debris storage vessel 40 is attached to the connection chamber 21 of the EUV light source apparatus 1 (FIG. 2), the debris collection vessel (see FIG. 14 etc.) that collects the stored material SU drained away from the drain pipe 50 is disposed below the debris storage vessel 40. In this case, as shown in the figures including FIG. 6A, if the outlet 54 stays in a horizontal position, problems may occur in the collection of the stored material SU. For this reason, a collection pipe 80 may be provided that directs the outlet 54 downward via a joint 65. This collection pipe 80 serves as a pipe connecting the outlet 54 with the debris collection vessel, which is not shown in the figure.

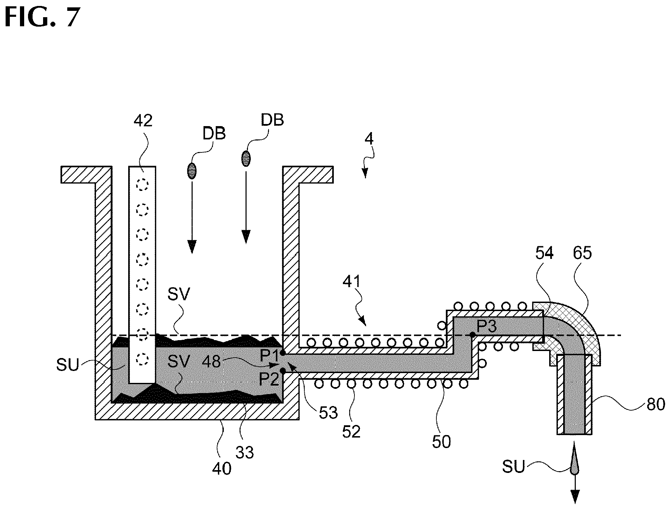

FIG. 7 is a schematic view illustrating an example of the configuration of the drain pipe 50 as a comparative example. FIG. 7 shows the drain pipe 50 configured by removing the aperture 51 from the drain pipe 50 shown in FIGS. 6A and 6B. Here, in the absence of the aperture 51, the drainage of the stored material SU through the collection pipe 80 mounted downwardly is considered. As shown in FIG. 7, when the exit of the collection pipe 80 is located below the inlet 53 of the drain pipe 50, the stored material SU stored in the debris storage vessel 40 continues to be drained away by the siphon principle even after its liquid surface level reaches the level of the lower end of the outlet 54. As a result, the liquid surface level of the stored material SU drops, arising the possibility that impurities SV floating on the liquid surface may enter the drain pipe 50.

In contrast, in the present embodiment as shown in FIG. 6B, the aperture 51 is provided inside the channel of the drain pipe 50. This makes it possible to restrict the flow rate of the stored material SU flowing through the drain pipe 50, limiting the amount of stored material SU drained from the outlet 54 even when the liquid is pulled by the siphon phenomenon.

Furthermore, when the cross section of the aperture channel 56 of the aperture 51 was suitably adjusted, this made it possible to suppress the excessive drainage of the stored material SU based on the siphon principle as described above. For example, as described with reference to FIG. 6A, adjusting the cross section of the aperture channel 56 in the range capable of reducing the amount of vacuum leakage from the drain pipe 50 when the drainage material SW was in a solid-phase state made it possible to suppress the excessive drainage of the stored material SU.

In this way, by providing an aperture 51 inside the channel of the drain pipe 50 and suitably adjusting the cross section of the channel of the aperture 51, this makes it possible to reduce the amount of vacuum leakage from the outlet 54 when the stored material SU is in a solidified state in the drain pipe 50. Furthermore, when the stored material SU drains away from the outlet 54 of the drain pipe 50 to the outside, this makes it possible to suppress the excessive drainage of the stored material associated with the siphon principle. Therefore, this makes it possible to avoid blockage of the channel of the drain pipe 50 and to perform the drainage operation in a stable manner.

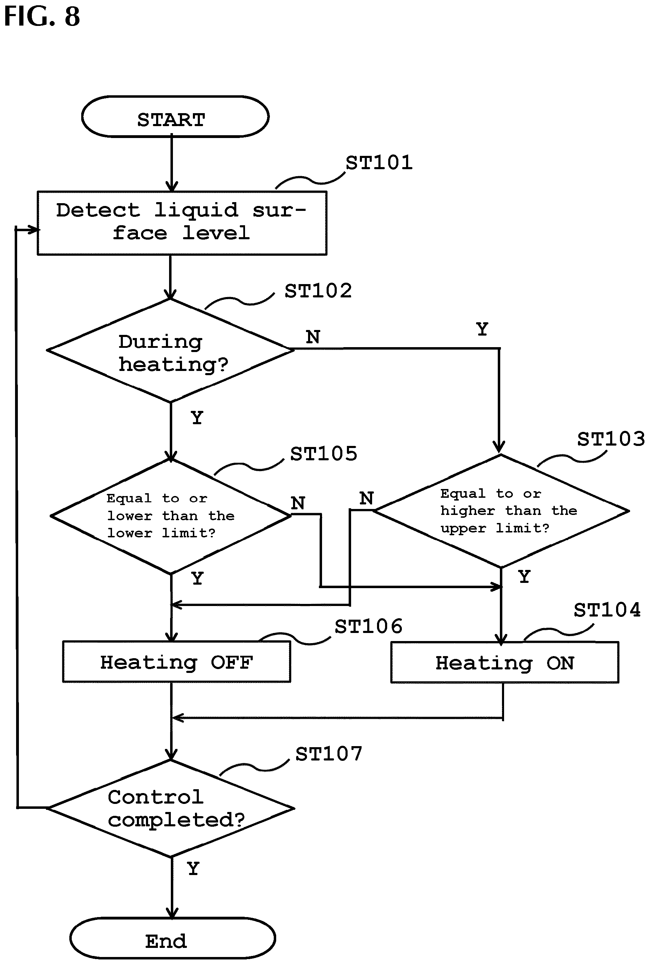

FIG. 8 is a flowchart illustrating an example of the basic operation of the debris storage and drainage section 4. The process shown in FIG. 8 is the process in which the debris storage and drainage section 4 switches between the drainage operation and the storage operation. This process basically controls the temperature of the drain pipe 50.

In the background of the process shown in FIG. 8, it is considered that the temperature control on the debris storage vessel 40 is constantly performed to make the stored material SU in the debris storage vessel 40 enter a liquid-phase state. Specifically, based on the temperature data measured by the storage vessel temperature sensor 46, the amount of power supplied from the storage vessel heating power supply 60 to the storage vessel heater 45 is controlled, maintaining the temperature of the debris storage vessel 40 at a temperature at which the stored material SU is in the liquid-phase state (e.g., 270°C). This makes it possible to perform the drainage operation of the stored material SU at any time.

First, the liquid surface level of the stored material SU in the debris storage vessel 40 is detected using the level sensor 42 (Step 101). The detected data is temporarily stored and used for subsequent threshold determination. Next, it is determined that whether the drain pipe 50 is being heated or not (Step 102). The drain pipe 50 being heated means that the drainage operation is being performed. The drain pipe 50 not being heated means that the storage operation is being performed. In other words, it can also be understood which of the drainage operation or storage operation is being performed is determined in Step 102.

If the drain pipe 50 is not being heated, which means the storage operation is being performed (No in Step 102), it is determined whether the liquid surface level L of the stored material SU is equal to or higher than the upper level Lₘₐₓ (Step 103). Here, the upper level Lₘₐₓ is, for example, the maximum liquid surface level L of the stored material SU stored in the debris storage vessel 40 during normal operation, and the liquid surface level at which the drainage operation is started. In the present embodiment, the upper level Lₘₐₓ corresponds to the first level.

If the liquid surface level L is equal to or higher than the upper level Lₘₐₓ (Yes in Step 103), the heating of the drain pipe heater 52 is switched to be ON and the drainage operation is started (Step 104). In this case, the drain pipe 50 is heated until it reaches a predetermined temperature at which the stored material SU is in a liquid-phase state, and maintains the temperature until the heating is switched to OFF. In this way, when the detection result of the level sensor 42 reaches the upper level Lₘₐₓ during the storage operation, the drainage operation is started. This enables the stored material SU from being drained away before the liquid surface level of the stored material SU reaches a level higher than necessary.

If the liquid surface level L is still lower than the upper level Lₘₐₓ (No in Step 103), the heating of the drain pipe heater 52 continues to be OFF (Step 106) as the liquid surface level L is still low, continuing the storage operation.

The process returns to Step 102 again. If the drain pipe 50 is being heated, which means the drainage operation is being performed (Yes in Step 102), it is determined whether the liquid surface level L of the stored material SU is equal to or higher than the lower level Lₘᵢₙ (Step 105). Here, the lower level Lₘᵢₙ is, for example, the minimum liquid surface level L of the stored material SU stored in the debris storage vessel 40 during the normal operation, and the liquid surface level at which the drainage operation is stopped and the storage operation is started. In the present embodiment, the lower level Lₘᵢₙ corresponds to the second level.

If the liquid surface level L is equal to or lower than the lower level Lₘᵢₙ (Yes in Step 105), the heating of the drain pipe heater 52 is switched to OFF, stopping the drainage operation and starting the storage operation (Step 106). In this way, when the detection result of the level sensor 42 reaches the lower level Lₘᵢₙ, which is lower than the upper level Lₘₐₓ, during the drainage operation, the storage operation is started. This stops the stored material SU from being drained away before the liquid surface level of the stored material SU reaches a level lower than necessary.

If the liquid surface level L is still higher than the lower level Lₘᵢₙ (No in Step 105), the heating of the drain pipe heater 52 continues to be ON (Step 104) as the liquid surface level L is still high, continuing the drainage operation.

After the heating of the drain pipe heater 52 is controlled to be ON and OFF in Step 104 and Step 106, respectively, it is determined whether the temperature control of the debris storage and drainage section 4 is stopped or not (Step 107). If the temperature control is not ended but continued (No in Step 107), the process starting from Step 101 is performed again. If the temperature control is terminated (Yes in Step 107), the loop process shown in FIG. 8 ends. The operation of each step will be described in more detail below.

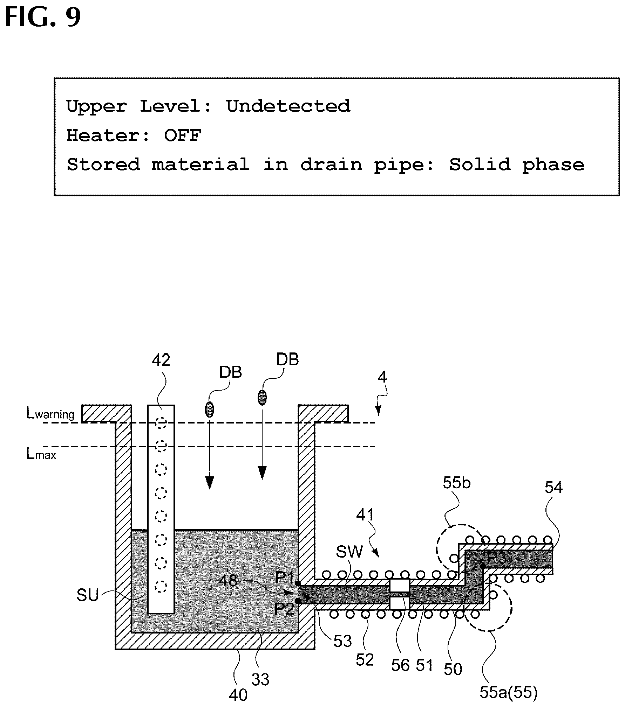

FIGS. 9 to 13 are each a schematic view illustrating the basic flow of operation of the debris storage and drainage section 4. Hereinafter, the basic operation of the debris storage and drainage section 4 shown in FIG. 8 will be described with reference to FIGS. 9 to 13.

Here, the drainage operation of the stored material SU is performed in a pressure environment below atmospheric pressure. In other words, the pressure at the outlet 54 and the pressure inside the debris storage vessel 40 are set below atmospheric pressure when the drainage operation is performed. Specifically, the pressure inside the debris storage vessel 40 is set to the pressure level at which the EUV light source apparatus 1 is operated. The pressure at the outlet 54 is set to, for example, nearly the same or lower than the pressure level at which the EUV light source apparatus 1 is operated.

This makes it possible to perform the drainage operation during the operation of the EUV light source apparatus 1 that generates the stored material SU. In other words, the stored material SU can be collected while the EUV light is being emitted. As a result, this eliminates the need for, for example, the downtime of the EUV light source apparatus 1 associated with the collection of the stored material SU, significantly improving the operating efficiency of the apparatus. In the following, it is considered that the process shown in FIG. 8 is performed during the operation of the EUV light source apparatus 1. The process shown in FIG. 8 can also be performed during the maintenance of the EUV light source apparatus 1 or the like, when the chamber is open to the atmosphere.

First, as shown in FIG. 9, the debris storage vessel 40 temporarily stores the debris DB and waste materials that have followed various paths as the stored material SU. As mentioned above, the stored material SU includes, as shown in FIG. 2, the debris DB and waste materials that are drained away from the drain hole 26 provided at the lower part of the cover 25, the debris DB and waste materials that move downward and fall off from the heat shield plate 23 due to its weight, and the debris DB and waste materials collected by an encircling member that surrounds the discharge sections such as the discharge electrodes EA and EB and stored through the receiving plate 18.

Hereinafter, the stored material SU (debris DB and waste materials) drained away from the debris storage vessel 40 may be referred to as the drainage material SW. For example, the stored material SU in the drain pipe 50 is referred to as the drainage material SW. The stored material SU drained away from the outlet 54 of the drain pipe 50 is also referred to as the drainage material SW.

For example, in the state shown in FIG. 9, the liquid surface level L of the stored material SU does not reach the upper level Lₘₐₓ. The controller 64 controls the drain pipe heating power supply 61 to stop supplying power to the drain pipe heater 52, which heats the drain pipe 50 (No in Step 102). This prevents the drainage material SW in the drain pipe 50 from maintaining a liquid-phase state, resulting in a solidified state (solid-phase state). Hence, the stored material SU stored in the debris storage vessel 40 is not drained away from the drain pipe 50. Meanwhile, since the debris DB and waste materials are constantly generated, the liquid surface level of the stored material SU gradually increases.

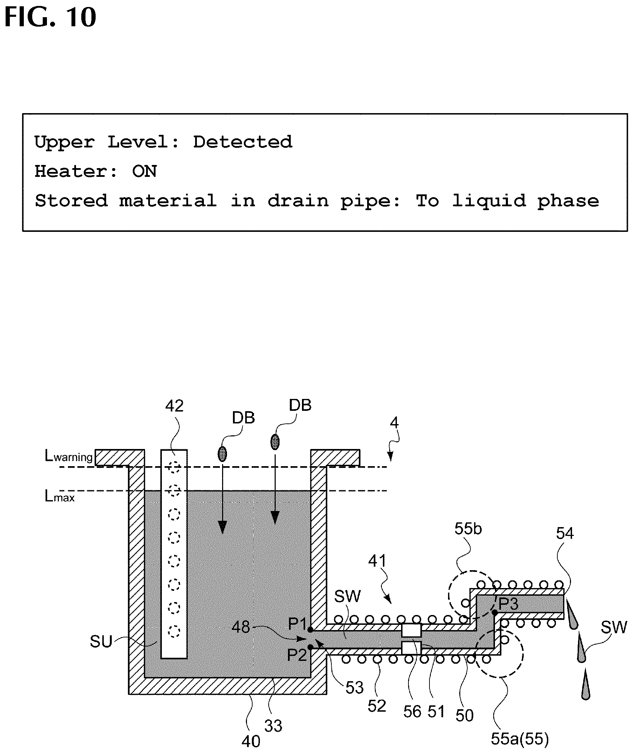

Next, as shown in FIG. 10, the case is considered when the amount of the stored material SU in a liquid-phase state stored in the debris storage vessel 40 increases, and the liquid surface level L of the stored material SU reaches the upper level Lₘₐₓ. In this case, the controller 64 determines that the liquid surface level L is equal to or higher than the upper level Lₘₐₓ upon receiving an upper level arrival signal from the level sensor 42 (Yes in Step 103). Then the controller 64 controls the drain pipe heating power supply 61 to supply power to the drain pipe heater 52 (Step 104). This allows the drainage material SW in the channel of the drain pipe 50 to change in a liquid-phase state, and then the stored material SU in the debris storage vessel 40 enters the drain pipe 50 through the inlet 53, and drains away from the outlet 54 through the channel of the drain pipe 50.

When the stored material SU stored in the debris storage vessel 40 is overflown into the interior of the connection chamber 21 shown in FIG. 2, the interior of the connection chamber 21 is contaminated by the stored material SU, which is undesirable. For this reason, in the present embodiment, a warning level L_{warning} is set at a position at which the liquid surface level of the stored material SU does not exceed the bottom of the connection chamber 21. The upper level Lₘₐₓ described above is set lower than this warning level L_{warning}. In other words, the upper level Lₘₐₓ is set at a lower height from the bottom of the debris storage vessel 40 than the warning level L_{warning}.

Hence, the case in which the liquid surface level L of the stored material SU reaches the warning level L_{warning} means that the liquid surface level L has exceeded the upper level Lₘₐₓ. In other words, even when the liquid surface level of the stored material SU reaches the upper level Lₘₐₓ, the stored material SU fails to be drained away from the outlet of the drain pipe 50 to the outside due to the occurrence of some errors (e.g., the drain pipe heater 52 does not work).

Upon receiving a signal (warning level arrival signal) from the level sensor 42 detecting that the liquid surface level L has reached the warning level L_{warning}, the controller 64 determines that some error described above has occurred and sends an error signal to the outside. The controller 64 may control the EUV light source apparatus 1 to stop its operation in response to receiving the warning level arrival signal.

In FIG. 8, the determination process associated with the warning level L_{warning} is omitted. When the warning level L_{warning} is detected, for example, the liquid surface level L exceeds at least the upper level Lₘₐₓ. Hence, the determination process associated with the warning level L_{warning} is performed, for example, after the liquid surface level L is determined to exceed the upper level Lₘₐₓ (Yes in Step 103), and before the drain pipe heater 52 is set to be ON in Step 104.

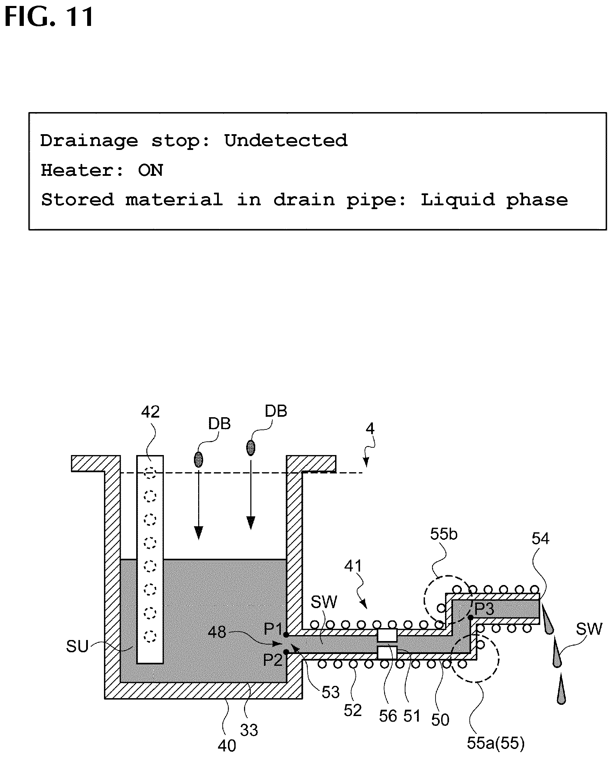

Then, as shown in FIG. 11, the drain pipe heating power supply 61 continues to supply power to the drain pipe heater 52 until the liquid surface level in the debris storage vessel 40 reaches a predetermined level (lower level Lₘᵢₙ). In other words, the drainage material SW flowing through the channel of the drain pipe 50 maintains a liquid-phase state, and the drainage material SW continues to drain away from the above-mentioned drain pipe 50.

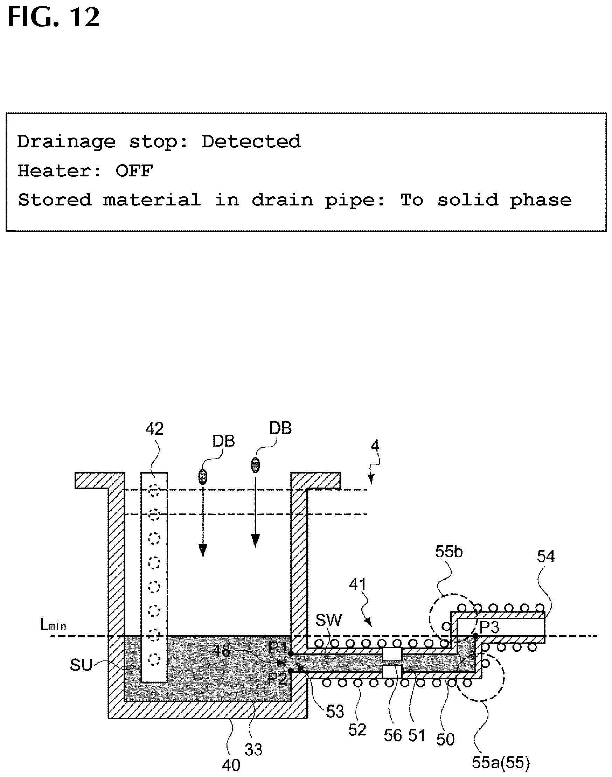

The drain pipe 50 is provided with the bent portion 55. As described above, the drain pipe 50 is provided with the bent portion 55a at which the drain pipe 50 is bent in the direction opposite to the direction of gravity between the aperture 51 and the outlet 54, and the bent portion 55b at which the drain pipe 50 extending in the direction opposite to the direction of gravity is bent in a direction away from the debris storage vessel 40. Hence, the drain pipe 50 becomes a structure that extends in the direction away from the debris storage vessel 40, and the height of the outlet 54 of the drain pipe 50 is higher than the upper end of the inlet 53 (the upper end of the connection opening 48 provided in the debris storage vessel 40). As a result, as shown in FIG. 12, when the liquid surface level L of the stored material SU in the debris storage vessel 40 is the same as the level of the lower end of the outlet 54, the drainage material SW is stopped draining away from the outlet 54 (see FIG. 5B).

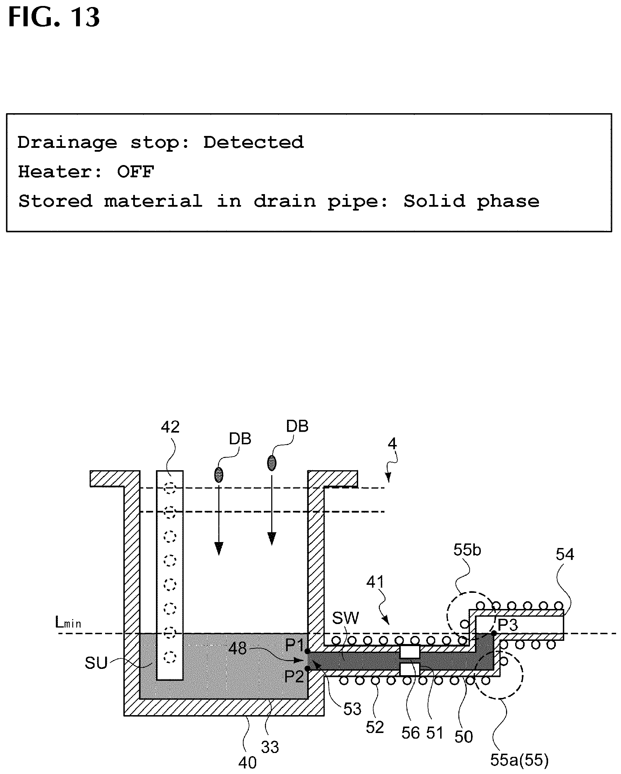

In FIG. 13, the heating by the drain pipe heater 52 is switched to be OFF in a state in which the liquid surface level L is the same as the level of the lower end of the outlet 54 as shown in FIG. 12. Here, the controller 64 controls the drain pipe heating power supply 61 to stop supplying power to the drain pipe heater 52 upon detecting the stopping of the drainage material SW from the outlet 54.

The method for detecting the stopping of the drainage material SW from the outlet 54 includes a method using an image acquisition means such as a camera, which is omitted from the figure. In this case, image recognition processing is performed on the images taken on the outlet 54 and the inside of the drain pipe 50 to determine whether the drainage material SW has stopped draining or not. For example, as shown in FIG. 8, the lower end level of the outlet 54 may be set as a drainage stop level (lower level Lₘᵢₙ) of the drainage material SW, and the detection result of the level sensor 42 may be used for the determination. The controller 64 uses detection information from such sensors (camera and level sensor 42) to detect the stopping of the drainage material SW from the outlet 54.

When the power to the drain pipe heater 52 is stopped, the drainage material SW located from the inlet 53 through the bent portion 55a to the lower end level of the outlet 54 in the drain pipe 50 switches from a liquid-phase state to a solid-phase state (solidified state). In other words, the stored material SU (drainage material SW) stored in the debris storage vessel 40 is no longer drained away from the drain pipe 50.

For example, during the operation of the EUV light source apparatus 1, the debris storage vessel 40, which is spatially connected to the connection chamber 21, is in a reduced-pressure atmosphere (vacuum state). Meanwhile, there may be a case in which the debris collection vessel 70 (see FIG. 14) is detached at the outlet 54 when the stored material SU in the channel of the drain pipe 50 is in a solidified state, then exposing the outlet 54 at an atmospheric atmosphere. Hence, the drain pipe 50 needs to serve as not only a valve that coordinates the drainage and the drainage stop of the stored material SU, but also a valve for vacuum sealing to maintain a reduced-pressure atmosphere on the side of the EUV light source apparatus 1 (side of debris storage vessel 40).

For this reason, the drain pipe 50 is provided with the bent portion 55 in such a way that the lower end of the outlet 54 is located higher than the upper end of the channel of the drain pipe 50 (upper end of the inlet 53) in which the aperture 51 is located. As a result, the channel portion of the drain pipe 50 in which the aperture 51 is located is always filled with the stored material SU (debris and waste raw materials), preventing the aperture 51 from coming into contact with the gap. Therefore, the drain pipe 50 serves as a vacuum seal valve (see FIGS. 6A and 6B).

In this way, in the debris storage and drainage section 4, the temperature of the drain pipe 50 is adjusted by switching the power of the drain pipe heater 52 to ON or OFF, switching the state of the stored material SU (debris and waste materials) in the channel of the drain pipe 50 to a liquid-phase state or a solid-phase state. This enables the drain pipe 50 itself to serve as a valve that controls the flow of the stored material SU temporarily stored in the debris storage vessel 40.

### Debris collection vessel

FIG. 14 is a schematic view illustrating an example of the configuration of the debris storage and drainage section 4 including the debris collection vessel 70. The debris storage and drainage section 4 shown in FIG. 14 includes, in addition to the configuration described with reference to FIG. 3, the debris collection vessel 70 and the collection pipe 80.

The debris collection vessel 70 is a container in which the stored material SU (drainage material SW) that drains away from the outlet 54 of the drain pipe 50 is collected. In the present embodiment, the debris collection vessel 70 corresponds to a collection vessel. The debris collection vessel 70 includes a vessel body 71, a lid 72, and an inner vessel 73. The vessel body 71 is a concave vessel that constitutes the outer wall portion of the debris collection vessel 70. The vessel body 71 is formed with a flange 74 on its top to enclose the opening portion thereof. The lid 72 is attached to the flange 74 using, for example, screws.

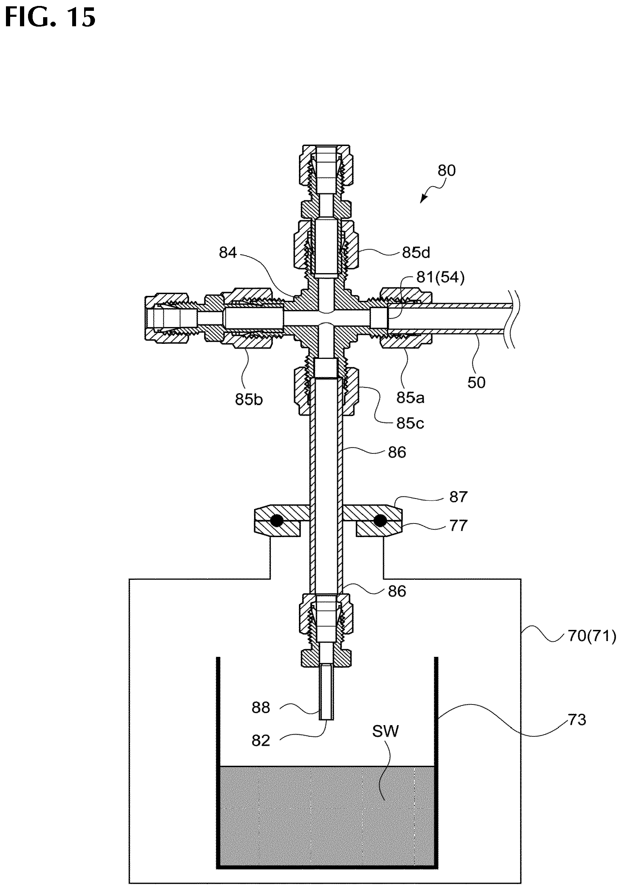

The lid 72 is configured to fit the shape of the flange 74 so as to block the opening of the vessel body 71. The lid 72 is provided with a collection port 75 and an exhaust port 76. The collection port 75 is a through-hole for collecting the drainage material SW (stored material SU) drained from the drain pipe 50. The collection pipe 80 to be described below is connected to the collection port 75. In addition, the collection port 75 is provided with a flange 77 on its upper end for connecting to the collection pipe 80 (see FIG. 15). The exhaust port 76 is a through-hole to exhaust the space inside the debris collection vessel 70. The exhaust port 76 is connected to an exhaust pipe 78 that is connected to an exhaust unit such as a vacuum pump (not shown). In this way, the debris collection vessel 70 is connected to the exhaust unit that reduces the pressure inside the vessel. The exhaust pipe 78 is also provided with a pressure gauge 79 to measure the pressure inside the debris collection vessel 70.

The vessel body 71 and the lid 72 are formed from, for example, stainless steel. The spacing between the flange 74 of the vessel body 71 and the lid 72 is sealed by a gasket. In this state, the space inside the debris collection vessel 70 is exhausted from the exhaust port 76 connected to the exhaust unit. As a result, the inside of the debris collection vessel 70 becomes a reduced-pressure atmosphere.

The inner vessel 73 is a vessel that is provided inside the vessel body 71, and collects the drainage material SW (stored material SU) that drains away through the collection pipe 80. The inner vessel 73 is configured to be thermally independent of the vessel body 71. In other words, the inner vessel 73 is configured to minimize the thermal contact with the vessel body 71. Since the debris collection vessel 70 is depressurized, the inner vessel 73 has a vacuum insulation structure. In this way, the debris collection vessel 70 is configured as an insulated vessel.

The collection pipe 80 is a pipe that connects the drain pipe 50 to the debris collection vessel 70, and has an inlet 81 and an outlet 82. The inlet 81 of the collection pipe 80 is connected to the drain pipe 50 via a joint 65. The outlet 82 of the collection pipe 80 is inserted into the debris collection vessel 70. A collection pipe heater 83 is provided around the collection pipe 80. The collection pipe heater 83 is an element that controls the temperature of the collection pipe 80. The collection pipe heater 83 is, for example, a fine-tube heater, which is wrapped around the entire collection pipe 80. The collection pipe heater 83 may be provided separately from the drain pipe heater 52, or the drain pipe heater 52 may be extended and used as the collection pipe heater 83.

FIG. 15 is a schematic diagram illustrating an example of the configuration of a collection pipe. FIG. 15 schematically illustrates an example of the cross-sectional configuration of the collection pipe 80 that connects the drain pipe 50 and the debris collection vessel 70. In FIG. 15, the configuration of the upstream side from the outlet 54 of the drain pipe 50 and the fine-tube type collection pipe heater 83 are omitted to be illustrated. The configuration of the debris collection vessel 70 is also simplified. The collection pipe 80 includes a cross-shaped joint 84, a connection pipe 86, a flange 87, and a tip portion 88.

The joint 84 is provided with horizontal connection ports 85a and 85b, and vertical connection ports 85c and 85d. The connection port 85a is connected to the outlet 54 of the drain pipe 50. The connection port 85b is connected to a collection pipe temperature sensor (not shown), which measures, for example, the temperature of the collection pipe 80. In this case, a sheath-type resistance temperature detector or the like is inserted along the connection port 85. The lower connection port 85c is connected to the connection pipe 86, which is inserted into the debris collection vessel 70. A cartridge heater (not shown in the figure) is inserted into the upper connection port 85d as the collection pipe heater 83 that heats the collection pipe 80. The cartridge heater is inserted, for example, in the channel constituted by the connection pipe 86 and the tip portion 88, and heats the entire collection pipe 80 from the inside thereof.

The connection pipe 86 is a straight pipe having a predetermined inner diameter. The tip portion 88 is provided at the end of the connection pipe 86, and is a pipe having a smaller inner diameter than the connection pipe 86. The connection pipe 86 is connected to the tip portion 88 through a joint, for example, to connect pipes of different diameters. Alternatively, they may be connected by brazing or welding.

The flange 87 is provided in the middle of the connection pipe 86 and is detachably connected to the debris collection vessel 70. The flange 87 is detachably connected to the flange 77 provided on the collection port 75 of the debris collection vessel 70. Examples of the flanges 77 and 87 include vacuum joints such as quick couplings that are easy to connect and disconnect. In this case, an O-ring, which serves as a sealing material, is provided between the flanges 77 and 87. In this way, in the collection pipe 80, a portion of the connection pipe 86 and the tip portion 88 provided at the end thereof constitute a nozzle protruding from the flange 87 into the interior of the debris collection vessel 70.

The following describes the operation of each section in the collection process to collect the drainage material SW (stored material SU) into the debris collection vessel 70. This collection process is performed in conjunction with the drainage operation. It is understood here that the collection process is performed during the operation of the EUV light source apparatus 1.

As described above, during the operation of the EUV light source apparatus 1, the interior of the light source section 2 (FIG. 1) and the connection chamber 21 (FIG. 2) is in a vacuum environment (reduced-pressure environment). Hence, when the drainage material SW is attempted to be drained away from the drain pipe 50 during the operation of the EUV light source apparatus 1, the debris storage vessel 40 is in a vacuum (reduced-pressure) state.

Here, the inventors conducted an experiment to confirm whether the drainage operation was properly performed with the experimental condition that the debris storage vessel 40 was in a vacuum (reduced-pressure) state and the outlet 54 of the drain pipe 50 was in an atmospheric pressure state. As a result, no drainage material SW was drained away from the outlet 54 of the drain pipe 50. This result is caused by the difference in pressure between the debris storage vessel 40 and the outlet 54 of the drain pipe 50. In contrast, with the experimental condition that the debris storage vessel 40 was in a vacuum (reduced-pressure) state and the outlet 54 was also in a vacuum (reduced-pressure) state, the drainage material SW was drained away from the outlet 54, when the stored material SU in the drain pipe 50 was in a liquefied state (state similar to that in FIG. 10 or 11). Hence, when the drainage material SW is attempted to be drained away from the drain pipe 50 during the operation of the EUV light source apparatus 1, the outlet 54 of the drain pipe 50 is preferably in a vacuum (reduced-pressure) environment.

Based on this finding, the inventors have developed a method in which the debris collection vessel 70 is in a vacuum (reduced-pressure) state when the drainage material SW (debris and waste materials) is drained away from the debris storage and drainage section 4 and collected into the debris collection vessel 70 during the operation of the EUV light source apparatus 1. In order to achieve such a collection method, the exhaust port 76 and the exhaust pipe 78 provided in the lid 72 of the debris collection vessel 70 are used to exhaust the air inside the debris collection vessel 70 as shown in FIG. 14, creating a vacuum (reduced-pressure) state. The pressure inside the debris collection vessel 70 is measured by a pressure gauge provided in the exhaust pipe 78. This configuration allows the drainage material SW to be readily collected even during the operation of the EUV light source apparatus 1.

In the debris collection vessel 70, the drainage material SW that drips from the tip portion 88 is stored in the inner vessel 73. At this time, the inner vessel 73 is heated by the heat of the drainage material SW, which is in a liquid-phase state. The inner vessel 73 also serves as a vacuum insulation vessel. Hence, the drainage material SW that drips into the inner vessel 73 is stored in the liquid-phase state. This makes it possible to prevent the drainage material SW that has been solidified from growing locally in the inner vessel 73.

When the drainage material stops draining away from the drain pipe 50, the collection by the debris collection vessel 70 is complete. Then, the drain pipe heater 52 is switched to be OFF, making the drainage material SW in the drain pipe 50 SW in a solidified state (see FIG. 13). In this state, the debris collection vessel 70 is detached from the collection pipe 80. At this time, the debris collection vessel 70 with a vacuum state is exposed to the atmosphere. Hence, the outlet 54 of the drain pipe 50 also has an atmospheric pressure through the collection pipe 80. Even in such a case, the vacuum in the EUV light source apparatus 1 (debris storage vessel 40) is not degraded because the drain pipe 50 and the aperture 51 serves as a vacuum seal. This makes it possible to perform the collection of the drainage material SW without interruption even during the operation of the EUV light source apparatus 1.

Next, the role of the respective parts of the collection pipe 80 is described. The configuration is considered such that, for example, the connection pipe 86 is not penetrated with respect to the flange 87. In this case, the nozzle protruding to the side of the debris collection vessel 70 is not configured. This configuration in which the flange 87 is flat at the side of the vessel causes the heat of the drainage material SW to escape into the flange 87, thus the drainage material SW may solidify before dripping down. A method of melting the drainage material SW that has been solidified by heating the flange 87 may be considered; however, this method takes time for heating. In addition, the temperature of a Viton O-ring, which is used at the vacuum joint, may exceed its heat resistance temperature. Also, even when the drainage material SW melts, it may flow along the flange 87, solidifying at an unintended location.

In contrast, the nozzle-shaped structure in which the connection pipe 86 and the tip portion 88 protrude from the flange 87 into the interior of the vessel is employed in the present embodiment. This structure allows the drainage material SW to be guided to a dripping position without dissipating heat to the flange 87. In addition, this structure suppress the drainage material SW from going around the flange 87, thus enabling the drainage material SW to securely dripping into the inner vessel 73. Furthermore, by introducing a cartridge heater through the cross-shaped joint 84, this makes it possible to efficiently heat the inside of the collection pipe. The cartridge heater can be controlled by a temperature sensor to prevent overheating.

In the present embodiment, the connection pipe 86 is provided with the tip portion 88 at its end, which supplements the channel. The experiment was conducted using a connection pipe 86 having a large inner diameter (e.g., 1/4-inch pipe) without the tip portion 88. In this case, the drainage material SW dripped smoothly in the air; however, the drainage material SW often went around the edge of the pipe and solidified in a vacuum. This is caused by the fact that the drainage material SW changes in various characteristics such as pressure, viscosity, surface tension, wettability, and heat conduction in a vacuum compared to those in the air. Hence, the inventors attached the tip portion 88 having a narrow inner diameter (e.g., 1/8-inch tube) to the connection pipe 86 having a larger inner diameter, and observed the state of the dripping in a vacuum. The result confirms that squeezing the diameter of the tip of the connection pipe 86 prevents the drainage material SW from going around the edge thereof. This structure avoids a situation in which the drainage material SW is accidentally clogged, enabling a stable collection processing.

The debris storage and drainage section 4 according to the present embodiment is provided with the drain pipe 50 that communicates with the debris storage vessel 40 in which the stored material SU containing metal of the plasma raw material is stored in a liquid-phase state. The drain pipe 50 is provided with the drain pipe heater 52, which switches temperature of the drain pipe 50 to allow the stored material SU in the drain pipe 50 to be in a liquid-phase state or a solid-phase state. This makes it possible to collect the stored material SU containing metal of the plasma raw material, without detaching the debris storage vessel 40.

### <Other embodiments>

The present invention is not limited to the embodiments described above, and can be applied to various other embodiments.

In the above, the EUV light source apparatus is described as one embodiment of the apparatus that utilizes liquid metal of the plasma raw material. Also described is the case in which the debris storage and drainage section according to the present invention is configured to be in the EUV light source apparatus. The application of the present invention is not limited to EUV light source apparatuses. The present invention can be applied to any apparatuses in which plasma is generated using liquid metal. The present technology may also be applied to apparatuses that supply metal of the plasma raw material. In this case, the present invention can be used as a method of suitably draining liquid metal stored in, for example, a reservoir.

In addition, the present invention can also be applied to any apparatuses that utilize liquid metal. The present invention can be applied to various cooling systems that use liquid metal as a refrigerant in various applications, such as the cooling of high-performance circuits, nuclear reactors, and radiation sources in the X-ray range. The present invention can also be applied to, for example, fast breeder reactors such as sodiumcooled fast reactors. The storage and drainage mechanism according to the present invention can also be applied to various apparatuses that operate using liquid metal, even in systems for applications different from cooling systems.

The configurations such as the EUV light source apparatus, the storage vessel, and the drain pipe described with reference to the drawings are merely one embodiment, and can be modified to the extent so as not to depart from the scope of the present technology. In other words, any other configurations may be adopted to implement the present technology.

In the present disclosure, words such as "about", "substantially", and "approximately" are suitably used to readily understand the explanation. On the other hand, there is no clear difference between the cases in which these words "about", "substantially", and "approximately" are used and the cases in which they are not used. In other words, in the present disclosure, concepts that define shape, size, position relationship, and state, such as "center", "middle", "uniform", "equal", "same", "perpendicular", "parallel", "symmetrical", "extending", "axial direction", "cylindrical shape", "cylindrical hollow shape", "ring shape", and "annular shape", are concepts including "substantially center", "substantially middle", "substantially uniform", "substantially equal", "substantially same", "substantially perpendicular", "substantially parallel", "substantially symmetrical", "substantially extending", "substantially axial direction", "substantially cylindrical shape", "substantially cylindrical hollow shape", "substantially ring shape", and "substantially annular shape". The concepts also include concepts having states in a predetermined range (e.g., ±10% range) with respect to, for example, "exactly center", "exactly middle", "exactly uniform", "exactly equal", "exactly same", "exactly perpendicular", "exactly parallel", "exactly symmetrical", "exactly extending", "exactly axial direction", "exactly cylindrical shape", "exactly cylindrical hollow shape", "exactly ring shape", "exactly annular shape", and the like. Hence, even when the words such as "about", "substantially", and "approximately" are not added, the concepts may include those that are expressed by adding "about", "substantially", "approximately", and the like. Conversely, states expressed by adding "about", "substantially", "approximately", and the like does not necessarily exclude their exact states.

In the present disclosure, expressions using the term "than" such as "greater than A" and "less than A" are expressions that comprehensively include concepts that include the case that is equal to A and concepts that do not include the case that is equal to A. For example, "greater than A" is not limited to the case where it does not include "equal to A"; however, it also includes "equal to or greater than A". Also, "less than A" is not limited to "less than A"; it also includes "equal to or less than A". Upon the implementation of the present technology, specific settings and other settings are suitably adopted from the concepts that are included in "greater than A" and "less than A" to achieve the effects described above.

Among the characteristic portions according to the present technology described above, it is also possible to combine at least two of the characteristic portions. In other words, the various characteristic portions described in each embodiment may be optionally combined without restricting to the embodiment. The various effects described above are merely examples and are not limitative; other effects may also be achieved.

## Claims

1. A storage and drainage mechanism (4) comprising:
a storage vessel (40) that stores a stored material (SU) containing metal of plasma raw material (SA, SB) at a temperature at which the stored material (SU) is in a liquid-phase state;
a drainage section (41) including
a drain pipe (50) including an inlet (53) through which the stored material (SU) flows in, and an outlet (54) through which the stored material (SU) drains away, the drain pipe (50) being communicated with an interior of the storage vessel (40), and
a temperature control element (46) that adjusts a temperature of the drain pipe (50); and
a temperature controller (64) that controls the temperature control element (46) to switch the temperature of the drain pipe (50) in a manner that the stored material (SU) in the drain pipe (50) is in either a liquid-phase state or a solid-phase state.

2. The storage and drainage mechanism (4) according to claim 1, wherein the drainage section (41) includes an aperture (51) that is located in a channel of the drain pipe (50) and that constitutes an aperture channel (56) having a cross-sectional area smaller than the channel of the drain pipe (50).

3. The storage and drainage mechanism (4) according to claim 2, wherein the drain pipe (50) includes a bent portion (55) at which the drain pipe (50) is bent such that at least part of a lower end of a channel inner surface of the drain pipe (50) is located higher than an upper end of the inlet (53).

4. The storage and drainage mechanism (4) according to claim 3, wherein the aperture (51) is disposed between the inlet (53) and the bent portion (55).

5. The storage and drainage mechanism (4) according to any one of claims 1 to 4, wherein the drain pipe (50) is connected to the storage vessel (40) such that a lower end of the inlet (53) is located higher than a bottom of the interior of the storage vessel (40) by a predetermined distance.

6. The storage and drainage mechanism (4) according to any one of claims 1 to 3, wherein the temperature controller (64) controls the temperature of the drain pipe (50) such that the stored material (SU) is in a liquid-phase state when a drainage operation in which the stored material (SU) is drained away is performed, and controls the temperature of the drain pipe (50) such that the stored material (SU) is in a solid-phase state when a storage operation in which the stored material (SU) is stored without draining the stored material (SU) is performed.

7. The storage and drainage mechanism (4) according to any one of claims 1 to 3, further comprising a volume sensor (42) that detects an amount of the stored material (SU) in the storage vessel (40),
wherein the temperature controller (64) controls the temperature control element (46) in response to a detection result of the volume sensor (42).

8. The storage and drainage mechanism (4) according to claim 6, wherein the drainage operation is performed in a state in which a pressure at the outlet (54) is substantially equal to a pressure inside the storage vessel (40), or the pressure at the outlet (54) is less than the pressure inside the storage vessel (40).

9. The storage and drainage mechanism (4) according to claim 8, wherein the pressure at the outlet (54) and the pressure inside the storage vessel (40) are less than or equal to atmospheric pressure.

10. The storage and drainage mechanism (4) according to any one of claims 1 to 3, further comprising a collection vessel (70) that collects the stored material (SU) that has been drained away from the outlet (54) of the drain pipe (50).

11. The storage and drainage mechanism (4) according to claim 10, wherein the collection vessel (70) is configured as an insulated vessel.

12. The storage and drainage mechanism (4) according to claim 10, wherein the collection vessel (70) is connected to an exhaust section that reduces the pressure inside the collection vessel (70).

13. The storage and drainage mechanism (4) according to claim 10, wherein the drainage section (41) includes a collection pipe (80) that connects the drain pipe (50) to the collection vessel (70), and the temperature control element (46) adjusts a temperature of the collection pipe (80).

14. The storage and drainage mechanism (4) according to claim 13, wherein the collection pipe (80) includes a flange (87) that is detachably connected to the collection vessel (70), and a nozzle that protrudes from the flange (87) into the interior of the collection vessel (70).

15. A light source apparatus (1) comprising:
a light source section (2) in which plasma (P) emitting extreme ultraviolet light from plasma raw material (SA, SB) containing metal is generated;
a storage vessel (40) that stores debris containing metal released from the plasma (P) as a stored material (SU) at a temperature at which the stored material (SU) is in a liquid-phase state;
a drainage section (41) that includes a drain pipe (50) including an inlet (53) through which the stored material (SU) flows in and an outlet (54) through which the stored material (SU) drains away, and a temperature control element (46) that adjusts a temperature of the drain pipe (50), the drain pipe (50) being communicated with an interior of the storage vessel (40); and
a temperature controller (64) that controls the temperature control element (46) to switch the temperature of the drain pipe (50) in a manner that the stored material (SU) in the drain pipe (50) is in either a liquid-phase state or a solid-phase state.

16. A storage and drainage method comprising:
adjusting a temperature of a storage vessel (40) in a manner that a stored material (SU) containing metal of plasma raw material (SA, SB) is in a liquid-phase state; and
switching a temperature of a drain pipe (50) by controlling a temperature control element (46) provided in the drain pipe (50) in a manner that the stored material (SU) in the drain pipe (50) that communicates with the interior of the storage vessel (40) is in either a liquid-phase state or a solid-phase state.
